# EUROPÄISCHE PATENTSCHRIFT

(11) **EP 2 406 671 B1**
(45) Veröffentlichungstag und Bekanntmachung des Hinweises auf die Patenterteilung: **01.07.2015**
(21) Anmeldenummer: 10704137.8
(22) Anmeldetag: 12.02.2010
(51) Int. Cl.: G02B 6/00, G02B 6/255, G02B 6/36, G02B 6/42, H01S 5/40, F02P 23/04

(54) **LASEREINRICHTUNG MIT EINEM DIODENLASER UND EINER VIELZAHL OPTISCHER FASERN**
LASER DEVICE COMPRISING DIODE LASER AND A PLURALITY OF OPTICAL FIBERS
DISPOSITIF LASER COMPORTANT UNE DIODE LASER ET PLUSIEURS FIBRES OPTIQUES

(30) Priorität: 11.03.2009 DE 102009001468
(43) Veröffentlichungstag der Anmeldung: 18.01.2012
(73) Patentinhaber: Robert Bosch GmbH, 70442 Stuttgart (DE)
(72) Erfinder: STOPPEL, Klaus, 74354 Besigheim (DE); HERDEN, Werner, 70839 Gerlingen (DE); SCHWARZ, Hans-Jochen, 70567 Stuttgart (DE); LETSCH, Andreas, 70565 Stuttgart (DE)
(86) Internationale Anmeldenummer: PCT/EP2010/051780
(87) Internationale Veröffentlichungsnummer: WO 2010/102880

(56) Entgegenhaltungen:
- WO-A1-2009/037036
- DE-A1-102005 057 617
- DE-A1-102007 061 655
- DE-B3-102004 006 932
- JP-A- 2006 301 415
- US-A- 5 546 487

## Beschreibung

### Stand der Technik

Die Erfindung betrifft eine Lichtquelle gemäß dem Oberbegriff des unabhängigen Anspruchs und ein Verfahren zur Herstellung einer Lichtquelle.

Eine derartige Lichtquelle ist aus der DE 10 2004 006 932 B3 bekannt und weist einen Diodenlaserbarren mit einer Vielzahl von schmalen Emittern auf, die in Richtung ihrer Längsachse in einer Reihe nebeneinander angeordnet sind. Dem Diodenlaserbarren ist eine Einrichtung zur Strahlführung und Strahlformung des aus ihm austretenden Laserstrahls zugeordnet, die eine Vielzahl von in einer Reihe nebeneinander angeordneten Lichtleitfasern enthält, in die der Laserstrahl einkoppelt. Es ist vorgesehen, die Lichtleitfasern auf der gegenüberliegende Seite zu einem Bündel zusammenzufassen, wobei nicht bestrahlte Lichtleitfasern, die zwischen den voneinander im Diodenlaserbarren beabstandet angeordneten Emittern liegen, aus dem Bündel ausgeschlossen werden.

Nachteilig an der aus dem Stand der Technik bekannten Lichtquelle ist es, dass die mechanische Festigkeit der Einrichtung zur Strahlführung und Strahlformung in dem Bereich, in dem die Einkopplung des Laserstrahls erfolgt, gering ist und dass somit die Handhabung der Einrichtung zur Strahlführung und Strahlformung erschwert ist. Überdies ist ihre Haltbarkeit herabgesetzt. Es ist ein erster Aspekt und die Aufgabe der Erfindung, diesen Nachteil zu überwinden.

Nachteilig an der aus dem Stand der Technik bekannten Lichtquelle ist ferner, dass in dem Bündel auch solche Fasern enthalten sind, in die nur vergleichsweise wenig Licht einkoppelt. Auf diese Weise vermindert sich die Strahldichte am Ausgang der Einrichtung zur Strahlführung und Strahlformung und die Anwendbarkeit des aus der Einrichtung zur Strahlführung und Strahlformung austretenden Lichts, beispielsweise zum optischen

Pumpen eines Festkörperlasers, ist herabgesetzt.

Weitere Aspekte der vorliegenden Erfindung betreffen Verfahren zur Herstellung von Lichtquellen der vorliegend offenbarten Art.

Aus der US5 546 487 A ist eine Lasereinrichtung mit einer Lichtquelle zu ihrer optischen Anregung gemäß dem Oberbegriff des Anspruchs 1 bekannt.

Aus der DE 10 2004 006 932 B3 ist es bekannt, eine Lichtquelle herzustellen, indem runde Lichtleitfasern in einem Endabschnitt nebeneinander angeordnet werden und mit ihrem Endbereich in eine Form eingelegt werden, in der sie durch ein Heißpressverfahren in einen Rechteckquerschnitt gebracht werden, wobei die nebeneinander angeordneten Fasern in dem Endbereich miteinander verschmelzen.

Bei dem aus dem Stand der Technik bekannten Herstellverfahren wird pro Arbeitsgang, bestehend aus Anordnen und Heißpressen von Fasern, jeweils nur eine einzige Einrichtung zur Strahlführung und Strahlformung hergestellt. Ferner ist die Anordnung von Lichtleitfasern in einem Endabschnitt vergleichsweise zeitaufwendig. Das aus dem Stand der Technik bekannte Verfahren hat somit den Nachteil einer geringen Wirtschaftlichkeit.

Bei der Durchführung der in Rede stehenden Verfahren, insbesondere im industriellen Maßstab, ist es von großer Bedeutung, dass eine Umformung der Fasern im gewünschten Maß tatsächlich stattfindet, andererseits aber eine übermäßige Verquetschung der Fasern sicher ausgeschlossen wird.

### Vorteile der Erfindung

Erfindungsgemäße Lichtquellen haben den Vorteil, dass die mechanische Festigkeit im Bereich der ersten Enden der optischen Fasern hoch ist, sodass die Lichtleiteinrichtung problemlos gehandhabt werden kann und sich durch eine hohe Haltbarkeit auszeichnet.

Erfindungsgemäß wird dies bei einer Lasereinrichtung mit einer Lichtquelle zu ihrer optischen Anregung, beispielsweise einer Lasereinrichtung eines Laserzündsystems einer Brennkraftmaschine, umfassend einen Diodenlaser mit einer Vielzahl von Emittern und eine Lichtleiteinrichtung, wobei die Lichtleiteinrichtung eine Vielzahl optischer Fasern umfasst und jede optische Faser ein erstes Ende und eine Seitenfläche aufweist, wobei die ersten Enden der optischen Fasern derart zu den Emittern angeordnet sind, dass durch die Emitter erzeugtes Licht in die ersten Enden der optischen Fasern einkoppelt, wobei die optischen Fasern zumindest im Bereich ihrer ersten Enden entlang ihrer Seitenflächen auf Stoß angeordnet sind, dadurch erreicht, dass die optischen Fasern im Bereich ihrer ersten Enden mit einem Faserträger verbunden sind.

Unter einem ersten Ende einer optischen Faser ist hierbei ein Ende einer optischen Faser in Richtung seiner Längsachse zu verstehen, beispielsweise bei einer zylindrischen Faser eine Grundfläche des Zylinders. Unter einer Seitenfläche einer optischen Faser ist dabei die Fläche zu verstehen, die eine optische Faser senkrecht zu ihrer Längsachse begrenzt, beispielsweise bei einer zylindrischen Faser die Mantelfläche des Zylinders. Unter optischen Fasern, die entlang ihrer Seitenflächen auf Stoß angeordnet sind, sind optische Fasern zu verstehen, von denen alle oder fast alle, zum Beispiel mehr als 90% der optischen Fasern, unmittelbar benachbarte optische Fasern entlang ihrer Seitenflächen berühren.

Bei einer Lichtquelle mit einer Lichtleiteinrichtung, wobei die Lichtleiteinrichtung eine Vielzahl optischer Fasern umfasst, wobei die optischen Fasern im Bereich ihrer ersten Enden mit einem Faserträger verbunden sind, ist als Bereich der ersten Enden der Fasern der gesamte Bereich aufzufassen, in dem die Fasern mit dem Faserträger verbunden sind.

Vorteilhafterweise ergibt sich eine besonders hohe mechanische Festigkeit der Lichtleiteinrichtung, wenn der Faserträger im Bereich der ersten Enden der optischen Fasern mit den Seitenflächen der Fasern verbunden ist und/oder wenn der Faserträger in Längsrichtung der optischen Fasern bündig mit den Fasern abschließt und/oder wenn es zur Ausbildung einer stoffschlüssigen Verbindung zwischen den optischen Fasern und dem Faserträger kommt.

Vorteilhafterweise ergibt sich eine besonders hohe mechanische Festigkeit der Lichtleiteinrichtung, wenn die Lichtleiteinrichtung neben dem Faserträger einen zweiten Faserträger aufweist, wobei die optischen Fasern zwischen den Faserträgern angeordnet sind. Auch in diesem Fall erhöht sich die mechanische Festigkeit der Lichtleiteinrichtung wenn eine Verbindung, insbesondere einer stoffschlüssige Verbindung, zwischen dem zweiten Faserträger und den optischen Fasern vorliegt und/oder wenn der zweite Faserträger in Längsrichtung der optischen Fasern bündig mit den optischen Fasern und/oder bündig mit dem Faserträger abschließt.

Durch die Wahl passender Materialien für die optischen Fasern und für den oder die Faserträger lässt sich der Vorteil erzielen, dass die erfindungsgemäße Vorrichtung besonders einfach herstellbar ist.

Erfindungsgemäß bestehen die optischen Fasern aus einem oder mehreren ersten Gläsern und der oder die Faserträger aus einem oder mehreren zweiten Gläsern und die Erweichungstemperatur des zweiten Glases oder die Erweichungstemperaturen der zweiten Gläser hat/haben einen höheren Wert als die Erweichungstemperatur des ersten Glases oder die Erweichungstemperaturen der ersten Gläser. In diesem Fall ist es möglich, selektiv eine Verformung der optischen Fasern vorzunehmen, während eine Verformung des Faserträgers oder der Faserträger weitgehend vermieden werden kann.

Vorteilhafterweise bestehen die optischen Fasern aus einem oder mehreren ersten Gläsern und der oder die Faserträger aus einem oder mehreren zweiten Gläsern und die Härte bei Raumtemperatur des zweiten Glases oder die Härten bei Raumtemperatur der zweiten Gläser hat/haben einen höheren Wert als die Härte bei Raumtemperatur des ersten Glases oder die Härten bei Raumtemperatur der ersten Gläser. In diesem Fall ist es möglich, eine Endbearbeitung der Lichtleiteinrichtung, beispielsweise eine Politur, vorzunehmen, bei der ein Verkratzen der Stirnflächen der optischen Fasern durch Abrieb des/der Faserträger ausgeschlossen ist.

Vorteilhafterweise bestehen die die optischen Fasern aus einem oder mehreren ersten Gläsern und der oder die Faserträger aus einem oder mehreren zweiten Gläsern und der Wärmeausdehnungskoeffizient des zweiten Glases oder die Wärmeausdehnungskoeffizienten der zweiten Gläser hat/haben einen etwa gleichen Wert wie der Wärmeausdehnungskoeffizient des ersten Glases oder die Wärmeausdehnungskoeffizienten der ersten Gläser. In diesem Fall ist das Auftreten von Spannungen und Rissen in der Lichtleiteinrichtung auch bei Temperaturwechseln sicher ausgeschlossen.

Vorteilhafterweise weisen die optische Fasern zumindest im Bereich ihrer ersten Enden in den Bereichen, in denen sie einander berühren und/oder in den Bereichen, in denen sie den Faserträger oder die Faserträger berühren, eine abgeplattete Form auf, was sich darin äußert, dass die Querschnitte der Fasern in diesen Bereichen einen größeren Krümmungsradius aufweisen als in den Bereichen, in denen sie weder einander noch den Faserträger oder die Faserträger berühren. Durch die Abplattung vergrößert sich die Kontaktfläche zwischen den Fasern und dem Faserträger oder den Faserträgern, sodass eine beständigere Verbindung zwischen diesen Teilen entsteht. Überdies wird der Raum vor den Emittern des Diodenlasers besser mit optischen Fasern aufgefüllt, sodass sich die Einkopplung in die Lichtleiteinrichtung verbessert. In einer besonders günstigen Ausführung sind die Fasern entlang ihrer Stirnfläche und/oder im Bereich ihrer ersten Enden so stark und oder so großflächig abgeplattet, dass sie einen rechteckigen oder trapezförmigen Querschnitt aufweisen.

Da eine runde Querschnittfläche der Fasern eine verlustarme Lichtleitung innerhalb der Fasern ermöglicht, für die Einkopplung aber eher ungünstig ist, ist in einer vorteilhaften Weiterbildung der Erfindung vorgesehen, dass die Querschnitte der Fasern innerhalb des Bereiches ihrer ersten Enden in Richtung vom ersten Ende der Fasern zum zweiten Ende der Fasern von einer von einer runden Form stark abweichenden Form, beispielsweise einer rechteckigen oder trapezförmigen oder zumindest nahezu rechteckigen oder nahezu trapezförmigen Form, in eine runde oder nahezu runde Form übergehen.

Zur Verbesserung der mechanische Stabilität und zur Verringerung von optischen Verlusten ist es vorteilhaft, wenn dieser Übergang kontinuierlich erfolgt, insbesondere kontinuierlich über den gesamten Bereich, in dem die Fasern auf dem Faserträger oder auf den Faserträgern angeordnet sind.

Die mechanische Stabilität der Fasern ist auch verbessert, wenn sich die Form der Querschnittsfläche der Fasern beim Übergang von dem Bereich, in dem die Fasern auf dem Faserträger oder auf den Faserträgern angeordnet sind, zu dem Bereich, in dem die Fasern auf dem Faserträger oder auf den Faserträgern angeordnet sind, nicht sprunghaft ändert, sondern weitgehend unverändert, insbesondere rund bleibt.

Erfindungsgemäß werden Lichtquellen, insbesondere der beschriebenen Art, hergestellt, indem eine Vielzahl von optischen Fasern auf einem Faserträger angeordnet werden, die angeordneten optischen Fasern im Bereich ihrer ersten Enden erwärmt werden und es nachfolgend zur Ausbildung einer insbesondere stoffschlüssigen Verbindung zwischen den erwärmten optischen Fasern und dem Faserträger oder den Faserträgern kommt.

Hierbei lässt sich das Verfahren besonders reproduzierbar durchführen, wenn die Anordnung der optischen Fasern so erfolgt, dass sie zumindest im Bereich ihrer ersten Enden entlang ihrer Seitenflächen untereinander auf Stoß angeordnet sind.

Vorteilhafterweise wird eine Verbindung beschleunigt herbeigeführt, wenn es bei dem Erwärmen der optischen Fasern zu einer Erweichung der optischen Fasern kommt und/oder wenn die optischen Fasern zwischen dem Faserträger und einer Gegenfläche angeordnet sind, wobei die auf die optischen Fasern wirkende Kraft mittels der Gegenfläche auf die optischen Fasern einwirkt. In diesem Fall entsteht eine verbesserte Wärmeleitung und es entsteht ein besonders intensiver Kontakt zwischen den einzelnen Oberflächen.

### Zeichnung

Figur 1 zeigt eine schematische Darstellung einer Brennkraftmaschine mit einer Laserzündeinrichtung.
Figur 2 zeigt schematisch eine Laserzündeinrichtung im Detail.
Die Figuren 3a, 3b, 3c und 3d zeigen schematisch ein Beispiel einer Lichtquelle.
Die Figuren 4, 4a zeigen schematisch den Aufbau und die Anordnung von optischen Fasern.
Die Figur 4b zeigt schematisch ein Beispiel der Anordnung von Lichtleiteinrichtung und Diodenlaser.
Die Figuren 5a, 5b und 5c zeigen schematisch ein weiteres Beispiel einer Lichtquelle.
Die Figuren 6, 7a, 7b, 7c, 7e, 7f, 7g, 7h und 7i zeigen exemplarisch und schematisch die Herstellung einer Lichtquelle.
Die Figuren 8a, 8b, 8c, 8d und 8e sowie die Figuren 9a und 9b zeigen schematisch ein weiteres Beispiel der Herstellung einer Lichtquelle.
Die Figuren 10, 11, 12, 13 und 14 zeigen weitere Beispiele der Herstellung einer Lichtquelle.
Die Figuren 15, 15a und 15b und 16 zeigen schematisch weitere Beispiele einer Lichtquelle.
Die Figuren 17a, 17b und 18 zeigen schematisch exemplarisch ein Herstellungsverfahren einer Lichtquelle.
Die Figuren 19 und 20 zeigen schematisch exemplarisch ein weiteres Herstellungsverfahren einer Lichtquelle.

### Beschreibung des Ausführungsbeispiels

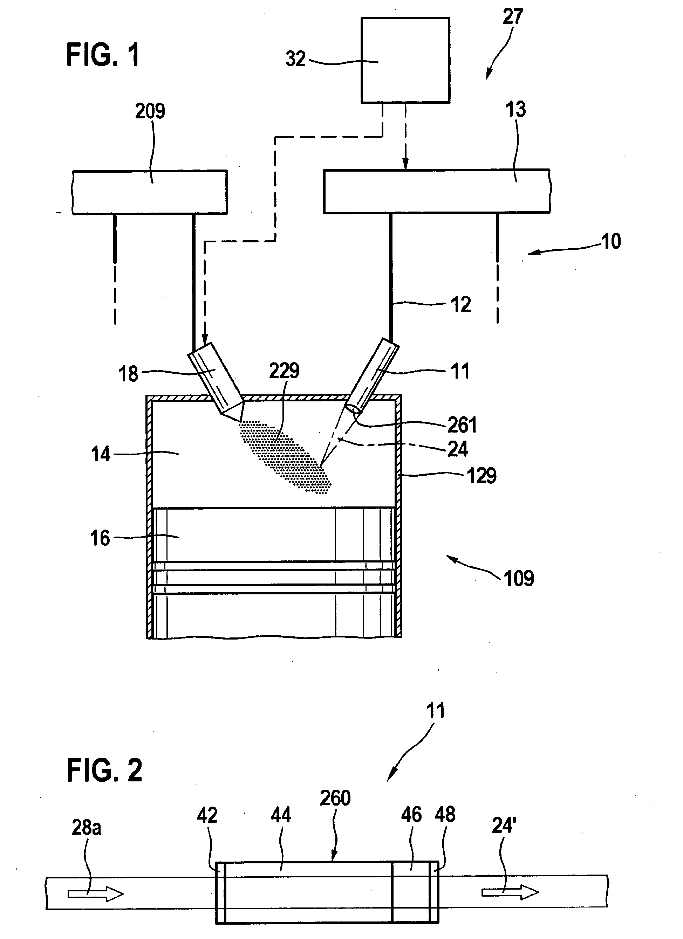

Eine Brennkraftmaschine trägt in Figur 1 insgesamt das Bezugszeichen 109. Sie dient zum Antrieb eines nicht dargestellten Kraftfahrzeugs oder eines ebenfalls nicht dargestellten Generators. Die Brennkraftmaschine 109 umfasst mehrere Zylinder 129, von denen in Figur 1 einer gezeigt ist. Ein Brennraum 14 des Zylinders 129 wird von einem Kolben 16 begrenzt. Kraftstoff 229 gelangt in den Brennraum 14 direkt durch einen Injektor 18, der an einen Kraftstoff-Druckspeicher 209 angeschlossen ist.

In den Brennraum 14 eingespritzter Kraftstoff 229 wird mittels eines Laserimpulses 24 entzündet, der von einer eine Lasereinrichtung 11 umfassenden Zündeinrichtung 27 in den Brennraum 14 abgestrahlt und mittels einer Fokussieroptik 261 fokussiert wird. Die Lasereinrichtung 11 wird von einer Lichtquelle 10 über eine Lichtleiteinrichtung 12 mit einem Pumplicht gespeist. Die Lichtquelle 10 wird von einer Steuer- und Regeleinrichtung 32 gesteuert, die auch den Injektor 18 ansteuert.

Die Lichtquelle 10 umfasst neben der Lichtleiteinrichtung 12 auch einen Diodenlaser 13, der in Abhängigkeit eines Steuerstroms ein entsprechendes Pumplicht über die Lichtleiteinrichtung 12 an die Lasereinrichtung 11 ausgibt.

Figur 2 zeigt schematisch eine Detailansicht des Festkörperlasers 260 der Lasereinrichtung 11 aus Figur 1. Wie aus Figur 2 ersichtlich, weist der Festkörperlaser 260 einen, nachfolgend als Laserkristall 44 bezeichneten, laseraktiven Festkörper auf, dem ein auch als Q-switch bezeichneter Kristall, der passive Güteschalter 46, optisch nachgeordnet ist. Der Festkörperlaser 260 weist ferner einen Einkoppelspiegel 42 und einen Auskoppelspiegel 48 auf. Die Komponenten des Festkörperlasers 260 sind in diesem Beispiel monolithisch ausgebildet, das heißt, sie sind weitgehend unlösbar miteinander verbunden, zum Beispiel durch Bonden und/oder Beschichten.

Zur Erzeugung eines auch als Riesenimpuls bezeichneten Laserimpulses wird der Laserkristall 44 durch den Einkoppelspiegel 42 hindurch mit Pumplicht 28a beaufschlagt, sodass es zu einem optischen Pumpen und zur Ausbildung einer Besetzungsinversion in dem Laserkristall 44 kommt. Zunächst befindet sich der passive Güteschalter 46 in seinem Ruhezustand, in dem er eine verhältnismäßig geringe Transmission für das von der Lasereinrichtung 11 zu erzeugende Licht aufweist. Auf diese Weise werden der Prozess der stimulierten Emission und damit die Erzeugung von Laserstrahlung zunächst unterdrückt. Mit steigender Pumpdauer, das heißt während einer Beaufschlagung mit dem Pumplicht 28a, steigt jedoch die Strahlungsintensität in dem Festkörperlaser 260 an, sodass der passive Güteschalter 46 schließlich ausbleicht. Hierbei steigt seine Transmission sprunghaft an, und die Erzeugung von Laserstrahlung setzt ein. Dieser Zustand ist durch den Doppelpfeil 24' symbolisiert. Während des Laserbetriebs erfolgt infolge des Effekts der stimulierten Emission ein rascher Abbau der im Laserkristall 44 vorliegenden Besetzungsinversion, sodass die Emission des Festkörperlasers 260 typischerweise nach einigen Nanosekunden zum Erliegen kommt, und nachfolgend sinkt auch die Transmission des Güteschalters 46 wieder auf ihren ursprünglichen, geringen Wert.

Auf die vorstehend beschriebene Weise entsteht ein auch als Riesenimpuls bezeichneter Laserimpuls 24, der eine verhältnismäßig hohe Spitzenleistung aufweist. Der Laserimpuls 24 wird, gegebenenfalls unter Verwendung einer weiteren Lichtleiteinrichtung (nicht gezeigt) oder auch direkt, durch ein ebenfalls nicht abgebildetes Brennraumfenster der Lasereinrichtung 11 in den Brennraum 14 (Figur 1) der Brennkraftmaschine 109 eingekoppelt, sodass darin vorhandener Kraftstoff 229 bzw. ein Luft/Kraftstoffgemisch entzündet wird.

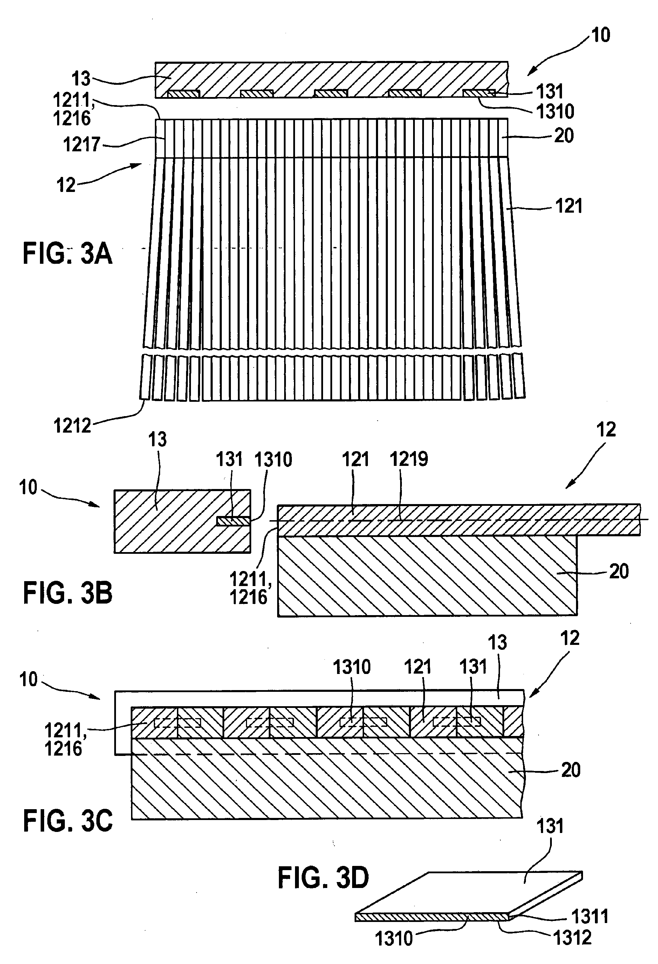

Die Figuren 3a, 3b, 3c und 3d zeigen eine schematische Ansicht eines Ausführungsbeispiels einer Lichtquelle 10. Der von der Lichtquelle 10 umfasste Diodenlaser 13 weist die Bauform eines sogenannten Diodenlaserbarrens auf. Er hat somit eine Vielzahl von nebeneinander angeordneten Emittern 131. Die Emitter 131 weisen eine Seitenfläche 1310 auf, durch die das von den Emittern 131 erzeugte Licht austritt. Diese Seitenfläche 1310 hat typischerweise eine etwa rechteckförmige Gestalt mit einer, üblicherweise als Fast-Axis bezeichneten, kurzen, zum Beispiel 1µm langen, ersten Seite 1311 und einer, üblicherweise als Slow-Axis bezeichneten, längeren, zum Beispiel 10 - 500µm langen, zweiten Seite 1312. Zwischen den in einer Schichtebene, in Richtung der Slow-Axis nebeneinander angeordneten Emittern 131 befinden sich als Trenngräben bezeichnete Bereiche, aus denen kein Licht emittiert wird. Das von den Emittern 131 erzeugte und aus den Seitenflächen 1310 austretende Licht hat jeweils die Form eines Lichtkegels, wobei der halbe Öffnungswinkel des Lichtkegels in der Ebene der Fast-Axis typischerweise im Bereich von 30° bis 60° liegt und allgemeinen deutlich größer ist als der Öffnungswinkel des Lichtkegels in der Ebene der Slow Axis, der typischerweise nur einige Grad beträgt.

Wenngleich in diesem Beispiel der Diodenlaser 13 die Bauform eines sogenannten Diodenlaserbarrens aufweist, ist die Erfindung nicht auf eine solche Bauform beschränkt, sondern umfasst beispielsweise auch Diodenlaser 13 mit anderen Anordnungen von Emittern 131, beispielsweise Anordnungen, die Emitter 131 in mehreren Schichtebenen aufweisen, wobei diese Schichtebenen beispielsweise in Richtung der Fast-Axis um einige Mikrometer zueinander versetzt sind, zum Beispiel sogenannte Diodenlaserstacks oder Nanostacks.

Die von der Lichtquelle 10 ebenfalls umfasste Lichtleiteinrichtung 12 weist eine Vielzahl von auch als optische Fasern 121 bezeichneten Fasern 121 auf, wobei die Fasern 121 jeweils ein erstes Ende 1211 und ein zweites Ende 1212 aufweisen. Die Fasern 121 sind im Bereich ihrer ersten Enden 1211 in einer Lage nebeneinander angeordnet. Ferner sind die Fasern 121 im Bereich ihrer ersten Enden 1211 so angeordnet, dass die den ersten Enden 1211 zugehörigen Stirnflächen 1216 der Fasern 121 gemeinsam in einer Ebene liegen. Ferner sind die Fasern 121 im Bereich ihrer ersten Enden 1211 entlang ihrer Seitenflächen 1217 auf Stoß angeordnet, also so angeordnet, dass alle Fasern 121 oder fast alle Fasern 121, zum Beispiel mehr als 90% der Fasern 121, unmittelbar benachbarte Fasern 121 im Bereich ihrer ersten Enden 1211 berühren.

In diesem Beispiel weisen die Stirnflächen 1216 der Fasern 121 eine im Wesentlichen rechteckige Form auf, desgleichen weisen Querschnitte der Fasern 121 im Bereich ihrer ersten Enden 1211 eine im Wesentlichen rechteckige Form auf. Hierbei berühren sich die Fasern 121 im Bereich ihrer ersten Enden 1211 flächig entlang annährend eben ausgebildeter Bereiche der Seitenflächen 1217 der Fasern 121. Jedoch ist die Erfindung selbstverständlich nicht auf Fasern 121, die im Bereich ihrer ersten Enden 1211 im Wesentlichen rechteckige Querschnitte aufweisen, eingeschränkt. Diese Querschnitte können auch trapezförmig sein oder geschwungene Seiten aufweisen, wobei es bevorzugt ist, dass sich die Fasern 121 im Bereich ihrer ersten Enden 1211 flächig entlang ihrer Seitenflächen 1217 berühren und dass die Stirnflächen 1216 der Fasern 121 gemeinsam in einer Ebene liegen, wobei die Stirnflächen 1216 der Fasern 121 gemeinsam möglichst dicht, das heißt ohne Einschlüsse freier Flächen, liegen.

Die Stirnflächen 1216 der Fasern 121 und Querschnitte der Fasern 121 haben untereinander einen zumindest weitgehend gleichen Flächeninhalt, der bevorzugt zwischen 3000 µm² und 5000 µm² liegt. Bevorzugt weisen die Stirnflächen 1216 der Fasern 121 und Querschnitte der Fasern 121, die im Bereich der ersten Enden 1211 der Fasern 121 liegen, die Form eines Rechteckes auf, dessen Seitenlängen ein Verhältnis von etwa 0,78 oder pi/4 bilden, wobei sich die Fasern 121 bevorzugt entlang der kurzen Seiten der Rechtecke berühren. Unter einem Querschnitt einer Faser 121 ist im Rahmen dieser Erfindung ein Querschnitt senkrecht zur Längsachse 1219 der Faser 121 zu verstehen.

Die Fasern 121 bestehen aus mindestens einem Glas, wobei jede individuelle Faser 121 bevorzugt aus mindestens zwei verschiedenen Gläsern besteht. Glasorten, die zum Einsatz kommen, sind beispielsweise sogenannte Flintgläser und/oder Kalknatrongläser.

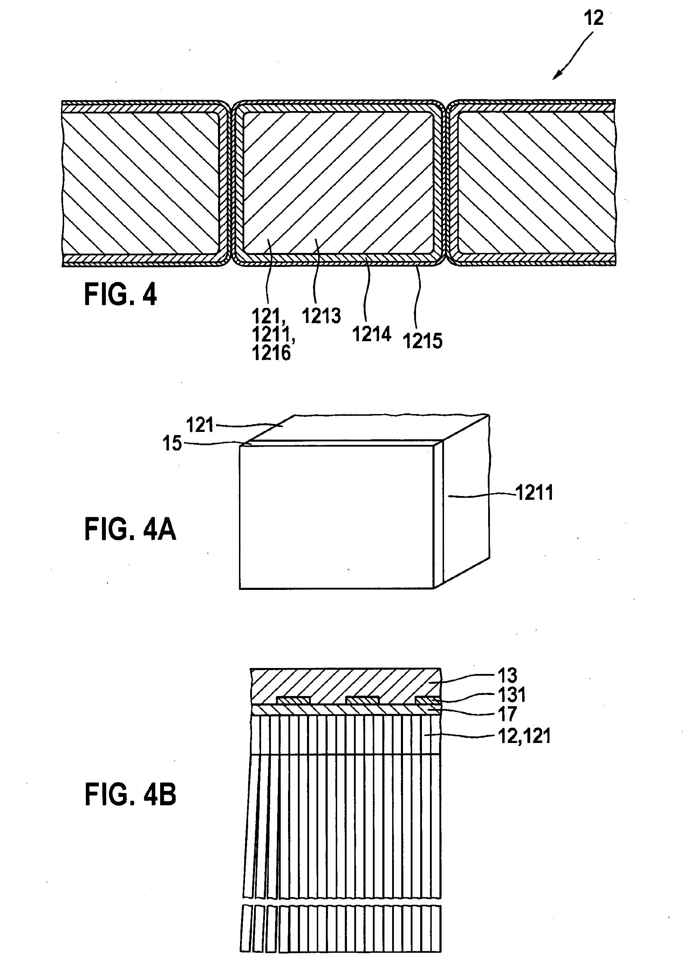

Figur 4 zeigt einen Ausschnitt der Lichtleiteinrichtung 12, insbesondere der den ersten Enden 1211 der Fasern 121 zugehörigen Stirnflächen 1216, die Querschnitte der Fasern 121 im Bereich ihrer ersten Enden 1211 repräsentieren. Im Querschnitt, beziehungsweise entlang der Stirnfläche 1216, einer Faser 121 wird ein zentral in der Faser 121 angeordneter Faserkern 1213 und ferner ein den Faserkern 1213 lateral, also senkrecht zur Längsachse 1219 der Fasern 121, umgebender Fasermantel 1214 sichtbar. Im Querschnitt, beziehungsweise entlang der Stirnfläche 1216, einer Faser 121 wird ferner eine den Fasermantel 1214 lateral umgebende Faserschlichte 1215 sichtbar. Sowohl die Stirnfläche 1216 der Faser 121 als auch Querschnitte der Fasern 121 im Bereich ihrer ersten Enden 1211 weisen in diesem Beispiel eine nahezu rechteckige Form auf. Desgleichen weisen im Bereich des ersten Endes 1211 der Fasern 121 Querschnitte des Faserkerns 1213 und des aus Faserkern 1213 und Fasermantel 1214 zusammengesetzten Gebildes und des aus Faserkern 1213 und Fasermantel 1214 und Faserschlichte 1215 zusammengesetzten Gebildes nahezu rechteckige Querschnitte auf.

Es ist vorgesehen, dass die Dicke des Fasermantels 1214 zumindest im Bereich der ersten Enden 1211 der Fasern 121 im Vergleich zur Querschnittsfläche, insbesondere im Vergleich zur Quadratwurzel des Flächeninhaltes der Querschnittsfläche, des Faserkerns 1213 gering ist, wodurch erreicht wird, dass ein hoher Anteil der Emission des Diodenlasers 13 in Faserkerne 1213 einkoppelt, wo er verlustarm geführt werden kann.

Um zu erreichen, dass das Licht, das dennoch in den Fasermantel 1214 einer Faser 121 einkoppelt, dort zumindest teilweise zum zweiten Ende 1212 der Faser 121 geführt wird, ist zusätzlich oder alternativ vorgesehen, dass der Faserkern 1213 aus einem ersten Material, der Fasermantel 1214 aus einem zweiten Material und die Faserschlichte 1215 aus einem dritten Material besteht, wobei das erste Material für das von dem Diodenlaser 13 erzeugte Licht, dessen Wellenlänge beispielsweise 808 nm beträgt, einen Brechungsindex n₁ hat, wobei das zweite Material für das von dem Diodenlaser 13 erzeugte Licht einen Brechungsindex n₂ hat und wobei das dritte Material für das von dem Diodenlaser 13 erzeugte Licht einen Brechungsindex n₃ hat und wobei gilt: n₁>n₂>n₃>1.

In diesem Beispiel hat der Faserkern 1213 im Bereich der ersten Enden 1211 der Faser 121 eine nahezu rechteckige Gestalt und Kantenlängen von 60 µm und 77 µm, der Fasermantel 1214 bildet eine etwa 2 µm dicke Schicht und die Faserschlichte 1215 eine etwa 0,05 µm dicke Schicht. Das erste Material, das Material des Faserkerns 1213, ist ein Glas mit einem Brechungsindex zwischen 1,5 und 1,6, beispielsweise Flintglas. Das zweite Material, das Material des Fasermantels 1214, ist ein Glas mit einem Brechungsindex zwischen 1,4 und 1,5, zum Beispiel Kalknatronglas. Das dritte Material, das Material der Faserschlichte 1215, ist ein Kunststoff und weist einen Brechungsindex zwischen 1,15 und 1,35 auf. Die Faserschlichte 1215 hat zusätzlich die Funktion, die Beständigkeit der Fasern 121 zu verbessern. Die Faserschlichte 1215 kann ein Überzug aus Lack (Acrylat oder Kunststoff) sein.

Die ersten Enden 1211 und/oder die zweiten Enden 1212 der Fasern 121 können eine Politur und/oder, wie in Figur 4a dargestellt, eine Antireflexschicht 15 aufweisen. Eine solche Politur und/oder eine solche Antireflexschicht 15 ist so ausgeführt, dass sie optische Verluste beim Eintritt/Austritt in/aus der Lichtleiteinrichtung 12 vermindert.

Alternativ oder zusätzlich ist es möglich, wie in Figur 4b schematisch dargestellt, einen Raum zwischen den ersten Enden der Fasern 1211 und den Emittern 131 des Diodenlasers 13 vollständig mit einem optisch homogenen Medium 17, zum Beispiel einem optischen Gel, auszufüllen, vorzugsweise mit einem Gel, dass optische Verluste bei der Einkopplung des von den Emittern 131 des Diodenlasers 13 erzeugten Lichts in die Fasern 121 vermindert und/oder einen Brechungsindex aufweist, der gleich oder etwa gleich, zum Beispiel um nicht mehr als 15% verschieden, dem Brechungsindex des Faserkerns n₁ ist.

Alternativ oder zusätzlich ist es möglich, die ersten Enden 1211 der Fasern 121 mit einem Abstand von 1 µm bis 10 µm vor den Emittern 131 des Diodenlasers 13 anzuordnen.

Wie in den Figuren 3a, 3b und 3c ersichtlich, sind die Fasern 121 im Bereich ihrer ersten Enden 1211 mit einem Faserträger 20 verbunden. Der in diesem Beispiel verwendete Faserträger 20 hat die Form eines quaderförmigen Scheibchens, erstreckt sich über die Breite, in der die Fasern 121 angeordnet sind, beispielsweise ca. 20 mm, hat eine in Richtung der Längsachsen 1219 der Fasern 121 orientierte Länge von 1 mm bis 20 mm, zum Beispiel bis 10 mm. Der Faserträger 20 schließt auf seiner dem Diodenlaser 13 zugewandten Seite mit den Stirnflächen 1216 der Fasern 121 bündig ab. Die Höhe des Faserträgers 20 liegt im Bereich von einigen zehntel Millimeter bis einigen Millimetern und ist typischerweise um ein Vielfaches höher als die Höhe der Fasern 121.

Der Faserträger 20 besteht aus einem Glas und ist mit den Fasern 121 im Bereich ihrer ersten Enden 1211 stoffschlüssig verbunden. Der Faserträger 20 besteht aus einem Glas, welches im Vergleich zu der Glassorte oder zu den Glassorten, aus denen die Fasern 121 bestehen, eine geringere Härte bei Raumtemperatur, einen vergleichbaren Wärmeausdehnungskoeffizient und/oder eine höhere Erweichungstemperatur hat. Glasorten, die zum Einsatz kommen, sind zum Beispiel Floatgläser.

Der Bereich, der vorliegend als Bereich der ersten Enden 1211 der Fasern 121 bezeichnet wird, ist als der Bereich der Fasern 121 aufzufassen, in dem die Fasern 121 auf dem Faserträger 20 angeordnet sind.

Der Verbund aus Fasern 121 und Faserträger 20 ist relativ zu dem Diodenlaser 13 fixiert, beispielsweise durch eine Klebung. Eine weitere Möglichkeit ist es, eine Fixierung durch Klemmen herzustellen, sodass sie zu einem späteren Zeitpunkt gelöst werden kann, zum Beispiel zwecks Demontage oder Nachjustieren.

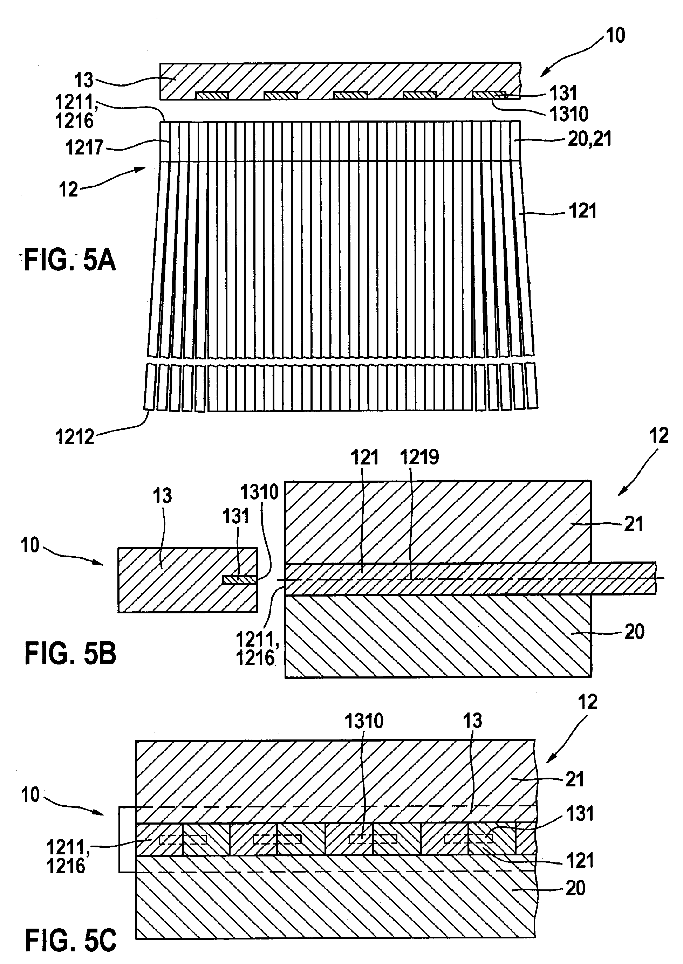

Eine weitere Ausführungsform ist in den Figuren 5a, 5b und 5c dargestellt. Diese weitere Ausführungsform unterscheidet sich von der in den Figuren 3a, 3b und 3c dargestellten Ausführungsform dadurch, dass die Fasern 121 im Bereich ihrer ersten Enden 1211 nicht nur auf einem Faserträger 20 angeordnet sind, sondern zwischen dem Faserträger 20 und einem zweiten-Faserträger-21 angeordnet-sind. Der Faserträger 20 und der zweite Faserträger 21 haben jeweils die Form eines quaderförmigen Glasscheibchens und sind beispielsweise gleich groß. Beispielsweise haben der Faserträger 20 und der zweite Faserträger 21 die im vorangehenden Beispiel für den Faserträger 20 angegebenen Abmessungen.

Zwischen den Faserträgern 20, 21 und den Fasern 121 besteht eine stoffschlüssige Verbindung und sowohl der Faserträger 20 als auch der Faserträger 21 schließt mit den Stirnflächen 1216 der Fasern 121 bündig ab.

Es ist einerseits möglich, dass die den Fasern 121 zugewandte Fläche des Faserträgers 20 und die den Fasern 121 zugewandte Fläche des zweiten Faserträgers 21 parallel zueinander sind, sodass der zwischen den Faserträgern 20, 21 verbleibende Spalt eine einheitliche Höhe hat. Alternativ sind die den Fasern 121 zugewandte Fläche des Faserträgers 20 und die den Fasern 121 zugewandte Fläche des zweiten Faserträgers 20 zueinander so verkippt, dass der zwischen den Faserträgern 20, 21 verbleibende Spalt im Bereich der Stirnflächen 1216 der Fasern 121 eine geringere Höhe aufweist als in dem den Stirnflächen 1216 der Fasern 121 gegenüberliegenden Bereich der Faserträger 20,21. Bevorzugt erfolgt eine Verkippung um einen Winkel von 0,1° bis 2,5°, zum Beispiel 0,2° bis 0,5°.

Entsprechend der Form des Spalts zwischen den Faserträgern 20, 21 ist eine kontinuierliche Verjüngung der Fasern 121 vorgesehen. Durch den kontinuierlichen Übergang zwischen einer der Einkopplung in die Fasern 121 zweckdienlichen Querschnittsform und einer der Lichtleitung in den Fasern 121 zweckdienlichen Querschnittsform werden abrupte Übergänge, die potenzielle mechanische Schwachstellen darstellen, vermieden.

Die beiden Faserträger 20,21 können bezüglich ihres Materials gleichartige, insbesondere gleiche Eigenschaften aufweisen. Bevorzugt besteht der zweite Faserträger 21 aus einem Glas, welches im Vergleich zu der Glassorte oder zu den Glassorten, aus denen die Fasern 121 bestehen, eine geringere Härte bei Raumtemperatur und/oder einen vergleichbaren Wärmeausdehnungskoeffizient und/oder eine höhere Erweichungstemperatur aufweist.

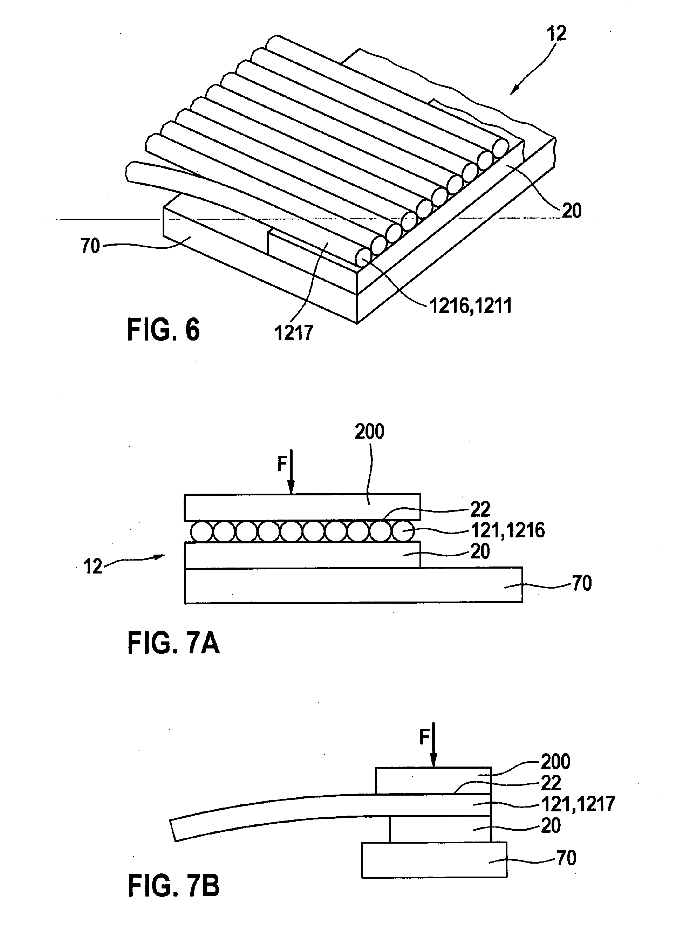

Im Folgenden wird anhand der Figur 6 beispielhaft die Herstellung einer Lichtquelle 10 erläutert. Ausgangspunkt ist ein Faserträger 20-mit-einer Höhe von 1mm, einer Länge von 5 mm und einer Breite von 14 mm. Längs der gesamten Breite des Faserträgers 20 werden optische Fasern 121, die runde Stirnflächen 1216 und runde Querschnittsflächen aufweisen und die eine Länge von etwa 1000 mm und einen Durchmesser von etwa 70 µm aufweisen, angeordnet, wobei die Fasern 121 im Bereich des Faserträgers 20 in einer Lage und entlang ihrer Seitenflächen 1217 auf Stoß liegen, das heißt, dass alle Fasern 121 oder fast alle Fasern 121, zum Beispiel mehr als 90% der Fasern 121, unmittelbar benachbarte Fasern 121 im Bereich ihrer ersten Enden 1211 entlang ihrer Seitenfläche 1217 berühren. Es kommt somit zur Anordnung von etwa 200 Fasern 121.

Die Fasern 121 sind relativ zueinander und relativ zu dem Faserträger 20, beispielsweise unter Ausnutzung einer gemeinsamen Anschlagfläche (nicht gezeichnet), so ausgerichtet, dass die Stirnflächen 1216 der Fasern 121 bündig miteinander und bündig mit dem Faserträger 20 abschließen.

Eine Erwärmung der auf dem Faserträger 20 angeordneten Fasern 121 erfolgt mittels einer Heizeinrichtung 70, beispielsweise mittels einer elektrischen Widerstandsheizung, beispielsweise auf eine Temperatur von 550° C bis 800°C, wobei die von der Heizeinrichtung 70 erzeugte Wärme den Fasern 121 im Beispiel durch den Faserträger 20 hindurch zukommt. In Folge der Erwärmung der Fasern 121 und des Faserträgers 20 kommt es zur Ausbildung einer stoffschlüssigen Verbindung zwischen den Fasern 121 und dem Faserträger 20.

In einer alternativen Ausführungsform des Verfahrens wird, wie in Figur 7a und 7b dargestellt, die Ausbildung einer Verbindung zwischen dem Faserträger 20 und den Fasern 121 dadurch unterstützt und beschleunigt, dass auf der dem Faserträger 20 abgewandten Seite der Fasern 121 eine Gegenfläche 22 eines Werkzeugs 200 mit den Fasern 121 unter Einwirkung einer Kraft F in Kontakt gebracht wird. Somit wird auch zwischen dem Faserträger 20 und den Fasern 121 eine Kraft erzeugt. Um zu vermeiden, dass sich eine Verbindung auch zwischen den Fasern 121 und der Gegenfläche 22 ausbildet, ist letztere aus mindestens einem hitzebeständigen Material, das sich auch unter Einwirkung von Wärme und Druck nicht mit Glas verbindet, beispielsweise aus SiC, auszubilden.

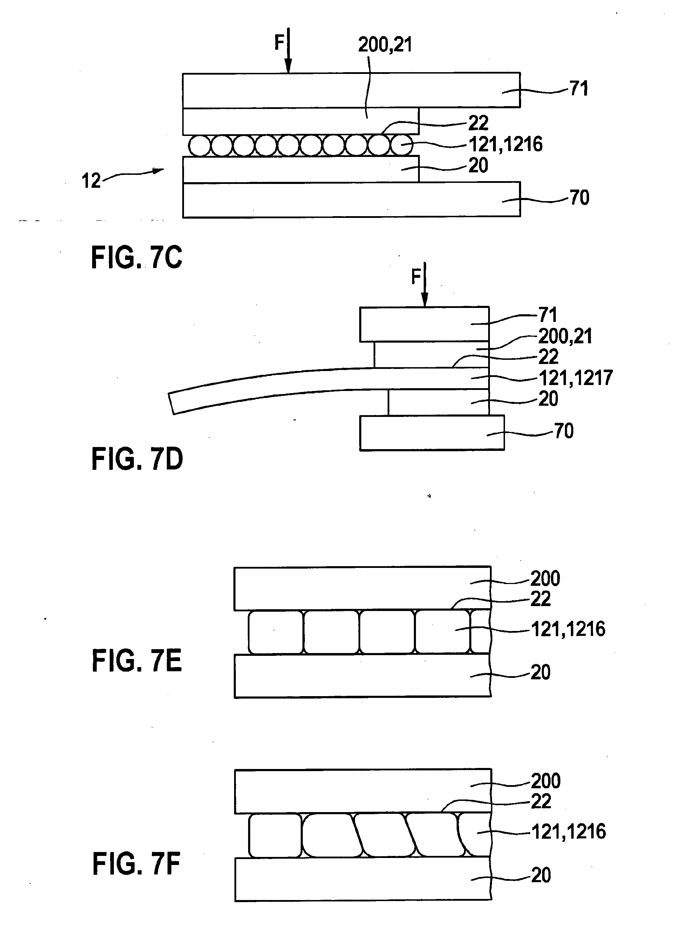

Alternativ kann die Ausbildung einer Verbindung zwischen der Gegenfläche 22 und den Fasern 121 auch erwünscht sein, insbesondere, wenn die Gegenfläche, wie in Figur 7c und 7d gezeigt, Teil eines zweiten Faserträgers 21 ist. In diesem Fall kann mittels einer zweiten Heizeinrichtung 71, beispielsweise mittels einer zweiten elektrischen Widerstandsheizung, die auf der der ersten elektrischen Widerstandsheizung 70 abgewandten Seite des Verbundes aus Fasern 121 und Faserträgern 20, 21 angeordnet ist, die Wärmezufuhr verbessert werden.

In einer alternativen Ausführungsform des Verfahrens ist die fortgesetzte Erwärmung der Fasern 121 mit einer Erweichung der Fasern 121 verbunden und/oder unter Einwirkung der durch die Gegenfläche 22 eingebrachten Kraft, kommt es zu einer Verformung der Fasern 121 im Bereich ihrer ersten Enden 1211. Hierbei ist, wie in Figur 7e gezeigt, zu beobachten, dass sich die zunächst runden Querschnittsflächen der Fasern 121 in den Bereichen, in denen die Fasern 121 einander oder den Faserträger 20 oder die Gegenfläche 22 berühren, abplatteten, die Krümmung der Seitenflächen 1217 der Fasern 121 in diesen Bereichen also abnimmt (Vergrößerung des Krümmungsradius), während die Krümmung in noch freien Bereichen der Seitenflächen 1217 der Fasern 121 zunimmt (Verkleinerung des Krümmungsradius). Wird die Einwirkung der Wärme und der Kraft weiter fortgesetzt, werden die Fasern 121 im Bereich ihrer ersten Enden 1211 weiter deformiert, solange, bis der Raum zwischen dem Faserträger 20 und der Gegenfläche 22 zumindest weitgehend vollständig durch die Fasern 121 ausgefüllt ist (Figur 7e). Die Fasern 121 weisen dann im Bereich ihrer ersten Enden beispielsweise rechteckige Querschnitte auf, insbesondere mit einem Seitenverhältnis von Pi zu 4, andererseits können auch weniger regelmäßig geformte Querschnittsflächen der Faser 121, beispielsweise trapezförmige Querschnitte oder geschwungene Querschnitte, resultieren (Figur 7f).

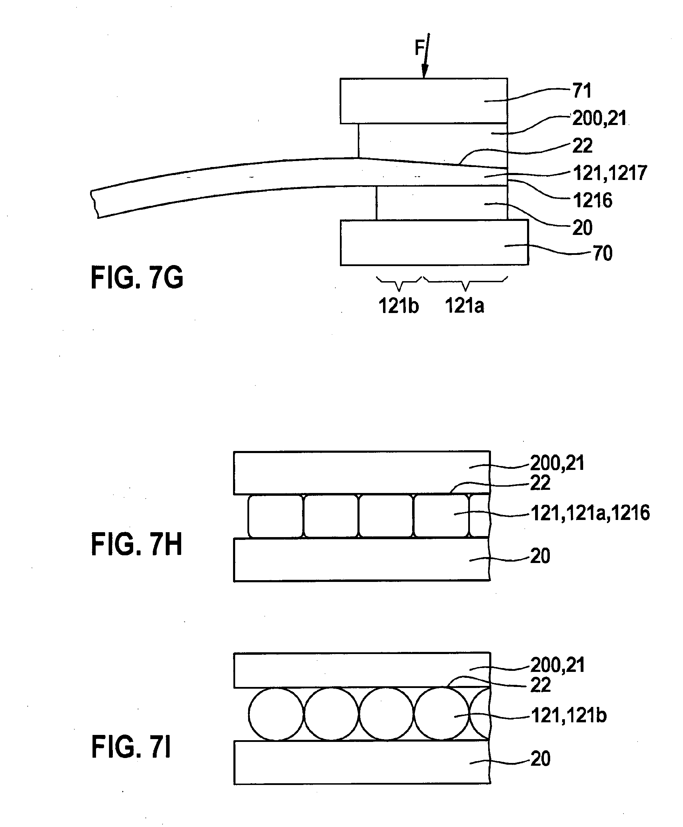

In einer anderen Ausführungsform ist vorgesehen, dass, wie in den Figuren 7g, 7h und 7i ersichtlich, die Fasern 121 in einem ersten Teilbereich 121a, der die Stirnflächen 1216 der Fasern 121 umfasst, stärker verpresst werden als in einem zweiten Teilbereich 121b, wobei der zweite Teilbereich 121b von den Stirnflächen 1216 der Fasern 121 beabstandet angeordnet ist. Beispielsweise werden die Fasern 121 im ersten Teilbereich 121a so stark verpresst, dass sie im Anschluss an die Verpressung nahezu rechteckige Stirnflächen 1216 aufweisen (Figur 7h). In diesem Beispiel werden die Fasern 121 im zweiten Teilbereich 121b so wenig verpresst, dass sie im zweiten Teilbereich 121b einen nahezu runden Querschnittsflächen beibehalten (Figur 7i).

Hierfür ist vorgesehen, dass die Gegenfläche 22 zur Auflagefläche der Fasern 121 auf dem Faserträger 20 einen Winkel von 0,1° bis 2,5° bildet. Alternativ-oder zusätzlich ist vorgesehen, dass die durch die Gegenfläche 22 auf den Fasern einwirkende Kraft zur Normalen der Auflagefläche der Fasern 121 auf dem Faserträger 20 einen Winkel von 0,1° bis 2,5° bildet, sodass es zu einer ungleichmäßigen Verpressung der Fasern 121 kommt.

Vorangehend wurde die Herstellung einer einzelnen Lichtquelle 10, insbesondere die Herstellung einer einzelnen Lichtleiteinrichtung 12, beschrieben. Es ist, wie nachfolgend exemplarisch beschrieben, zusätzlich oder alternativ möglich, in einem Arbeitsgang jeweils mehrere Lichtquellen 10, insbesondere jeweils mehrere Lichtleiteinrichtungen 12, herzustellen.

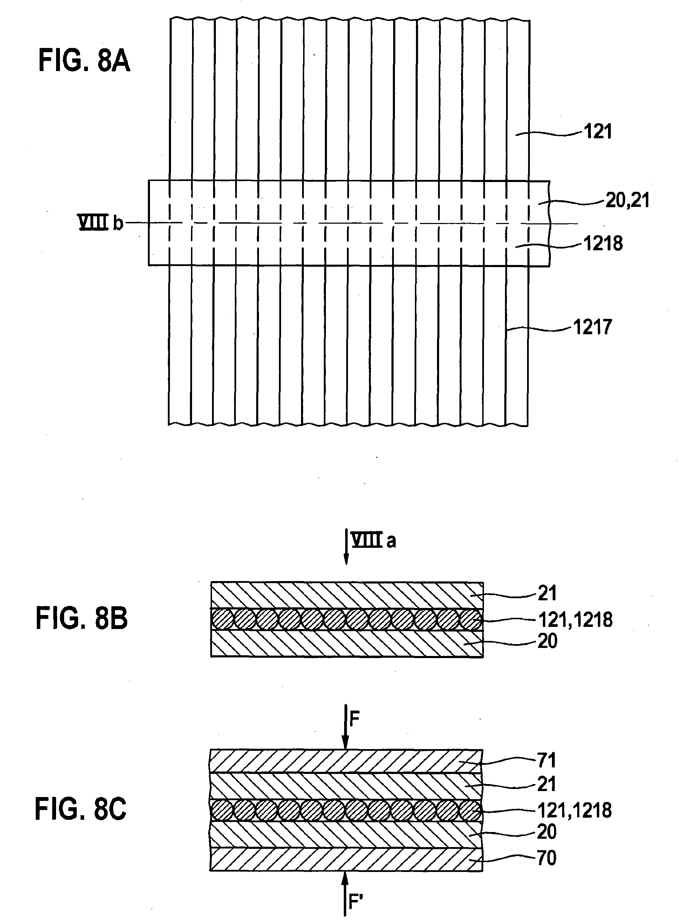

Hierfür werden beispielsweise, wie in Figur 8a und 8b dargestellt, eine Vielzahl von Fasern 121, insbesondere eine sehr große Anzahl von Fasern 121, zum Beispiel 1000 oder mehr Fasern 121, nebeneinander angeordnet, sodass die Fasern 121 in einem Faserabschnitt 1218 entlang ihrer Seitenfläche 1217 auf Stoß liegen, das heißt so angeordnet, dass alle Fasern 121 oder fast alle Fasern 121, zum Beispiel mehr als 90% der Fasern 121, unmittelbar benachbarte Fasern 121 im Bereich ihrer ersten Enden 1211 entlang ihrer Seitenflächen 1217 in dem Faserabschnitt 1218 berühren.

Die Fasern 121 sind so angeordnet, dass der Faserabschnitt 1218 in Längsrichtung der Fasern 121 zumindest etwa in der Mitte der Fasern 121 liegt. Die Fasern 121 liegen ferner in dem Faserabschnitt 1218 auf einem Faserträger 20 auf, der beispielsweise eine Glasplatte ist und eine Höhe von etwa einem Millimeter, eine Länge von einigen Millimetern und eine Breite von 50 mm bis 200 mm oder mehr aufweist. In diesem Beispiel wird ein zweiter Faserträger 21, dessen Eigenschaften bezüglich Geometrie und Material mit denen des Faserträgers 20 übereinstimmen, gegenüber dem ersten Faserträger 20auf die Fasern 121 aufgelegt.

In der Figur 8c sind die nachfolgenden Verfahrensschritte schematisch dargestellt. Diese Verfahrensschritte umfassen ein Erwärmen des Faserträgers 20 und des Faserträgers 21 mit zwei als elektrische Widerstandsheizungen ausgebildeten Heizeinrichtungen 70, 71. Indirekt werden somit auch die Fasern 121 erwärmt, in diesem Beispiel auf 550 bis 850°C. Ferner umfassen diese Verfahrensschritte die Einwirkung einer Kraft F auf den Faserträger 20 und die Einwirkung einer Kraft F' auf den zweiten Faserträger 21. Die Kräfte-F und-F' sind einander entgegengerichtet und so orientiert, dass insgesamt über die beiden Faserträger 20, 21 ein Druck auf die Fasern 121 ausgeübt wird, beispielsweise ein Druck von 0,5 N/cm² bis 50 N/cm².

Aufgrund der Einwirkung des Drucks kommt es zu einer Verformung der Fasern 121 im Bereich zwischen dem Faserträger 20 und dem zweiten Faserträger 21, wobei die Fasern 121 im Bereich zwischen dem Faserträger 20 und dem zweiten Faserträger 21 zunächst runde Querschnittsflächen aufweisen und sich diese runden Querschnittsflächen infolge der der Verformung der Fasern 121 wie oben beschrieben deformieren.

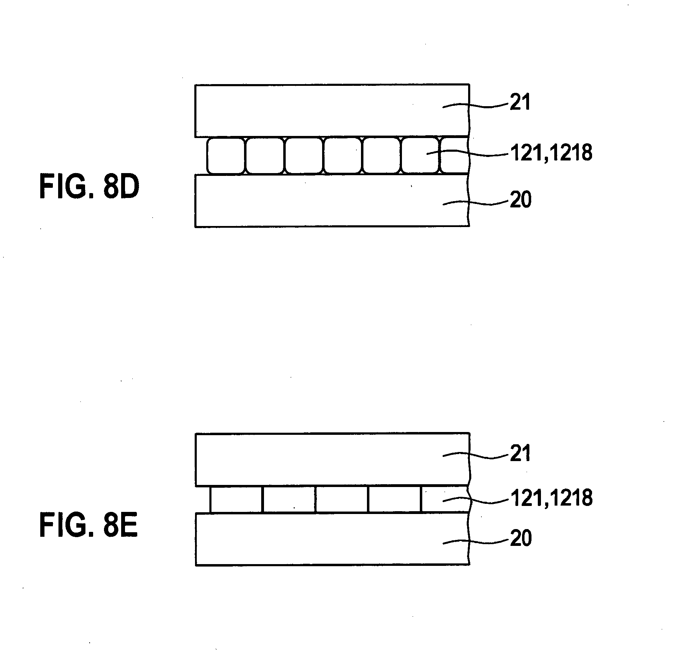

Ein Beispiel für entsprechend deformierte Fasern 121 ist ferner in Figur 8d gezeigt, wobei die Querschnittsflächen der Fasern 121 in den Bereichen, in denen die Fasern 121 die Faserträger 20, 21 oder einander berühren, Abplattungen aufweisen. In der Figur 8e ist ein weiteres Beispiel gezeigt, in dem die Fasern 121 den Bereich zwischen dem Faserträger 20 und dem zweiten Faserträger 21 weitgehend ausfüllen, sodass die Gesamtheit der Fasern 121 den zwischen den Faserträgern befindlichen Raum weitgehend vollständig ausfüllen. Die Querschnitte der einzelnen Fasern 121 im Bereich zwischen den Faserträgern 20, 21 können rechteckig oder trapezförmig sein.

Nachfolgend erfolgt eine Abkühlung der Fasern 121 und der Faserträger 20, 21, wobei es zur Verfestigung der Fasern 121 kommt und wobei sich zwischen Fasern 121 und den Faserträgern 20, 21 eine stoffschlüssige Verbindung ausbildet.

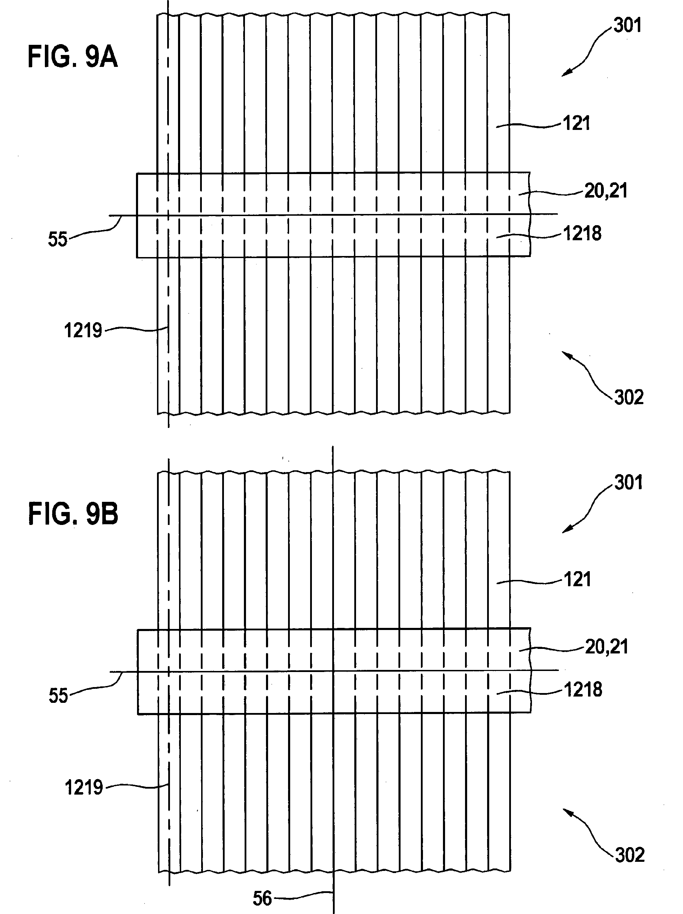

Wie in Figur 9a schematisch dargestellt, ist es in diesem Beispiel vorgesehen, dass nachfolgend der Verbund aus Faserträger 20, Fasern 121 und zweitem Faserträger 21 mittels eines Schnitts 55, der etwa senkrecht zu den Längsachsen 1219 der Fasern 121 im Bereich des Faserabschnitt 1218 der Fasern 121 vorgenommen wird, in zwei etwa gleiche Teile 301, 302 getrennt wird. Der Schnitt 55 kann beispielsweise in an sich bekannter Art und Weise mittels einer Diamantsäge oder mittels Ritzen und Brechen oder mit Hilfe eines Laserstrahls, zum Beispiel Infrarot-Laser, insbesondere CO₂-Laser, durchgeführt werden.

Es ist optional möglich, die beiden so erhaltenen Teile 300, 301 oder eine Vielzahl von so erhaltenen Teilen 301, 302 aufeinander zu stapeln und gemeinsam zu polieren und/oder mit einer Antireflexionsschicht zu versehen.

Die erhaltenen Teile 301, 302-können als zwei Lichtleiteinrichtungen 12 aufgefasst werden, die gemeinsam hergestellt wurden.

Optional ist es ferner auch möglich, wie in Figur 9b schematisch dargestellt, die Teile 301, 302 einzeln oder gemeinsam durch einen oder mehrere zweite Schnitte 56, die im Bereich des Faserabschnitts 1218 der Fasern 121 längs der Längsachsen 1219 der Fasern 121 durchgeführt werden, weiter zu zerteilen und so eine Vielzahl von Lichtleiteinrichtungen 12 zu erzeugen. Die zweiten Schnitte 56 können flexibel durchgeführt werden, insbesondere so, dass die Breite der erzeugten Lichtleiteinrichtungen 12 der Breite der Diodenlaser 13 entsprechen, mit denen sie zusammenwirken.

Die zweiten Schnitte 56 können ebenso wie die Schnitte 55 durchgeführt werden, beispielsweise mittels einer Diamantsäge oder mittels Ritzen und Brechen oder mit Hilfe eines Laserstrahls, zum Beispiel Infrarot-Laser, insbesondere CO₂-Laser.

Es ist insbesondere möglich, zur Durchführung der zweiten Schnitte 56, die Teile 301, 302 oder eine Vielzahl von Teilen 301, 302 zu stapeln, sodass bei jedem zweiten Schnitt 56 eine Vielzahl von Lichtleiteinrichtungen 12 vereinzelt wird.

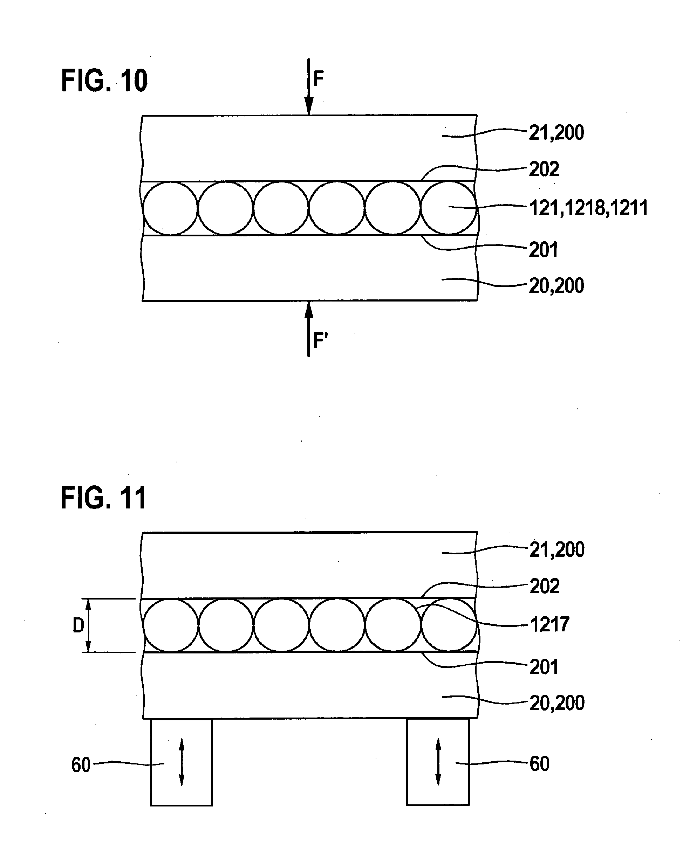

Wie vorstehend erläutert, kann die Herstellung einer Lichtquelle 10, vorsehen, dass es unter Einwirkung einer Kraft F auf die erwärmten Fasern 121 im Bereich der ersten Enden 1211 der Fasern 121 oder in einem, beispielsweise etwa mittigen, Faserabschnitt 1218 der Fasern 121 zu einer Verformung der erwärmten Fasern 121 kommt, beispielsweise so, dass die Gesamtheit der verformten Fasern 121 einen Bereich zwischen einem Faserträger 20 und einem zweiten Faserträger 21 vollständig ausfüllt. Selbstverständlich ist es auch möglich, den Faserträger 20 und/oder den zweiten Faserträger 21 durch ein Werkzeug 200, beispielsweise aus SiC, zu ersetzen, das sich nicht mit den Fasern 121 verbindet und das nach Verformung der Fasern 121 entfernt wird. Wesentlich ist, dass die Fasern 121, wie in Figur 10 dargestellt, zwischen zwei Pressflächen 201, 202 angeordnet sind, durch die die Kraft F und die Gegenkraft F' auf die Fasern 121 einwirkt. In diesem Fall weist die hergestellte Vorrichtung nicht zwei Faserträger 21, 22 auf, sondern höchstens einen Faserträger 21. Es ist in diesem Fall besonders bevorzugt, die ersten und/oder zweiten Schnitte 55, 56 durch Ritzen und Brechen einzubringen.

Im nachfolgenden Beispiel werden die Kräfte F und F' so gewählt, dass es zwar zu einer Verformung der Fasern 121 kommt, diese Verformung aber zum Stillstand kommt, wenn die Fasern 121 einen Bereich zwischen den Pressflächen 201,202 erstmals zumindest weitgehend (zum Beispiel >99,5 % des Querschnitts) ausfüllen. Hierbei wird sowohl eine zu geringe Kraft F, die zum Verformen der Faser 121 nicht ausreichend wäre, als auch eine zu große Kraft, die zum seitlichen Heraustreten der Fasern 121 aus dem Bereich zwischen den Pressflächen 201, 202 führen würde, vermieden.

Konkret wurden 140 Fasern aus Flintglas/Kalknatronglas zwischen zwei Pressflächen 201, 202 der Größe 15mm * 8mm angeordnet und auf ca. 630°C, also oberhalb der Erweichungstemperatur der Fasern 121 erhitzt. Nachfolgend wurden die Fasern 121 mit einer Kraft F beaufschlagt. Das gewünschte Verhalten wurde für Kräfte zwischen 1N und 35 N beobachtet.

Selbstverständlich ist es in gewissen Grenzen möglich, die Fasern 121 bis zu einer höheren oder geringeren Temperatur zu erhitzen, woraus eine erhöhte oder verminderte Fließfähigkeit der Fasern 121 resultiert. Der Bereich der Kraft F, in dem das Verhalten, dass es zwar zu einer Verformung der Fasern 121 kommt, diese Verformung aber zum Stillstand kommt, wenn die Fasern 121 einen Bereich zwischen den Pressflächen 201,202 erstmals zumindest weitgehend (zum Beispiel >99,5 % des Querschnitts) ausfüllen, auftritt, verschiebt sich in diesem Fall und kann durch Versuche aufgefunden werden. Im vorliegenden Beispiel wurde das erwünschte Verhalten für Kräfte F zwischen 10 N und 20 N und Fasertemperaturen zwischen 590°C und 690°C erreicht.

In einer anderen Ausführungsform ist zusätzlich oder alternativ vorgesehen, dass die Höhe des zwischen den Pressflächen 201,202 verbleibenden Spaltes ermittelt wird, wobei die Ausübung der Kraft F beendet wird, wenn der ermittelte Wert einen vorgegebenen Wert erreicht oder überschreitet, also dann, wenn die Höhe des zwischen den Pressflächen 201, 202 verbleibenden Spaltes eine vorgegebenen Höhe erreicht oder überschreitet.

Die Ausübung der Kraft kann einerseits beendet werden, wenn die Fasern 121 einen Bereich zwischen den Pressflächen 201, 202 zumindest weitgehend (zum Beispiel >99 % der Querschnittsfläche) ausfüllen, andererseits kann auch eine andere Höhe gewählt werden. In der in der Figur 11 gezeigten Ausführungsform sind Fasern 121 mit zunächst rundem Querschnitt und dem Durchmesser D, der in diesem Beispiel 100 µm beträgt, einlagig und entlang der Seitenflächen 1217 der Fasern 121 auf Stoß zwischen zwei Pressflächen 201, 202 eingelegt. Die Pressflächen 201, 202 sind jeweils entweder Teil eines Faserträgers 20, 21, der sich mit den Fasern 121 verbindet oder eines Werkzeugs 200, zum Beispiel aus SiC, das mit den Fasern 121 keine Verbindung eingeht.

Die Pressflächen 201, 202 sind über Aktoren 60, hier beispielsweise über Piezoaktoren, verschiebbar, wobei die Verschiebung der Pressflächen 201, 202 durch ein an die Aktoren 60 angelegtes Signal, beispielsweise durch eine Spannung, ausgelöst wird. Es ist vorgesehen, dass der tatsächliche Abstand der Pressflächen 201, 202 zueinander erfasst wird, beispielsweise auf Basis der an die Aktoren angelegten Signale oder durch ein optisches System.

In diesem Beispiel wird die Lage der Pressflächen 201,202 relativ zueinander vor Anlegen einer Spannung an den Piezoaktor dadurch referenziert, dass die Pressflächen 201, 202 in Kontakt mit den noch nicht erweichten Fasern 121 gebracht werden. Nachfolgend wird die an die Piezoaktoren angelegte Spannung schrittweise oder kontinuierlich erhöht, bis die angelegte Spannung einer Längenausdehnung der Piezoaktoren von 22µm entspricht. Zu diesem Zeitpunkt wird der zwischen den Pressflächen 201,202 befindliche Raum zumindest weitgehend vollständig von den deformierten Fasern 121 ausgefüllt.

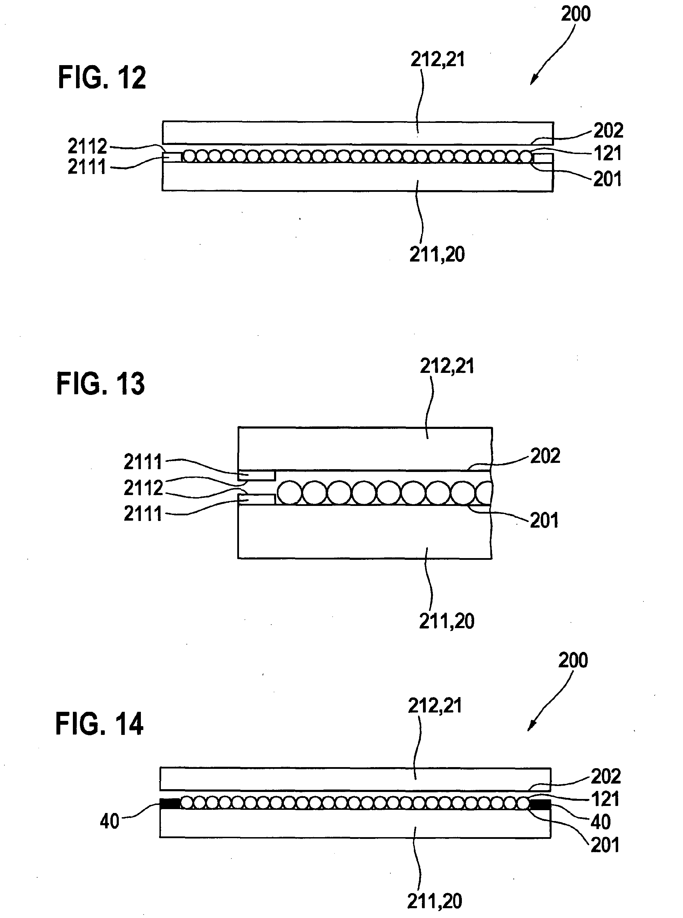

In alternativen Ausführungen ist vorgesehen, dass die Höhe des zwischen den Pressflächen 201,202 verbleibenden Spaltes dadurch gegeben ist, dass die Pressung mittels eines Presswerkzeugs 200 erfolgt, das aus zwei Teilen 211, 212 besteht, wobei die erste Pressfläche 201 dem ersten Teil 211 des Presswerkzeugs 200 zugeordnet ist und die zweite Pressfläche 202 dem zweiten Teil 212 des Presswerkzeugs 200 zugeordnet ist. Wie in der in Figur 12 gezeigt, weist hierbei das erste Teil 211 des Presswerkzeugs 200 in seinen Außenbereichen einen Vorsprung 2111 auf. Der Vorsprung 2111 ist so geformt und angeordnet, dass er eine Anschlagfläche 2112 aufweist, die plan zur zweiten Pressfläche 202 ist. Es ist zur definierten Verformung der erwärmten Fasern 121 vorgesehen, dass die beiden Teile 211,212 des Presswerkzeuges 200 einander soweit angenährt werden, bis die Anschlagfläche 2112 des Vorsprungs 2111 des ersten Teils 211 des Presswerkzeugs 200 mit der zweiten Pressfläche 202 in Kontakt kommt. Der zwischen den Pressflächen 201,202 verbleibende Spalt ist somit durch die durch den Vorsprung 2111 gegebene Maßverkörperung definiert.

Selbstverständlich ist es möglich, dass alternativ oder, wie in Figur 13 gezeigt, zusätzlich, der zweite Teil 212 des Presswerkzeugs 200 in seinen Außenbereichen einen Vorsprung 2111 aufweist. Insbesondere ist es möglich, dass beide Teile 211, 212 des Presswerkzeugs 200, zum Beispiel in ihren Außenbereichen Vorsprünge 2111 aufweisen, wobei die Vorsprünge 2111 zueinander parallele Anschlagflächen 2112 aufweisen. Es ist in diesem Fall zur definierten Verformung der erwärmten Fasern 121 vorgesehen, dass die beiden Teile des Presswerkzeuges 201, 202 einander soweit angenährt werden, bis die Anschlagflächen 2112 der Vorsprünge 2111 des ersten Teils 211 und des zweiten Teils 212 des Presswerkzeugs 200 miteinander in Kontakt kommt. Der zwischen den Pressflächen 201,202 verbleibende Spalt ist somit durch die durch die Vorsprünge 2111 gegebene Maßverkörperung definiert.

Die vorstehend als erstes Teil 211 und zweites Teil 212 des Presswerkzeugs 200 bezeichneten Teile können einerseits beide im engen Wortsinn Werkzeuge, beispielsweise aus SiC, sein, die mit den Fasern 121 auch unter Einwirkung von Wärme und Druck, zum Beispiel bei Temperaturen bis 800°C und Drücken bis 50 N/cm², keine Verbindung eingehen. Andererseits ist es möglich, dass, wie in den Figuren 12 und 13 durch Verwendung der Bezugszeichen 20 und 21 angedeutet, das erste Teil 211 des Presswerkzeugs 200 ein Faserträger 20 ist und/oder das zweite Teil 212 des Presswerkzeugs 200 ein zweiter Faserträger 21 ist, wobei der Faserträger 20 und/oder der zweite Faserträger 21 bevorzugt aus einem Glas bestehen und mit den Fasern 121 unter Einwirkung von Wärme und Druck eine stoffschlüssige Verbindung eingehen.

In einem weiteren Beispiel ist vorgesehen, dass die Höhe des zwischen den Pressflächen 201,202 verbleibenden Spaltes dadurch gegeben ist, dass die Pressung mittels eines Presswerkzeugs 200 erfolgt, dass aus zwei Teilen 211, 212 besteht, wobei die erste Pressfläche 201 dem ersten Teil 211 des Presswerkzeugs 200 zugeordnet ist und die zweite Pressfläche 202 dem zweiten Teil 212 des Presswerkzeugs 200 zugeordnet ist und wobei zwischen den Pressflächen 201, 202, beispielsweise in einem Außenbereich des Presswerkzeugs 200, ein Distanzstück 40 angeordnet ist oder mehrere Distanzstücke 40 angeordnet sind.

In der in Figur 14 gezeigten Ausführung dieses Beispiels ist zu beiden Seiten der Fasern 121 jeweils ein Distanzstück 40 angeordnet. Die Distanzstücke 40 weisen eine Höhe auf, die der Höhe des Spaltes entspricht, der zwischen den Pressflächen 201, 202 verbleiben soll. Die Distanzstücke 40 bestehen entweder aus einem Material, dass mit den Fasern 121 auch unter Einwirkung von Wärme und Druck, zum Beispiel bei Temperaturen bis 800°C und Drücken bis 50 N/cm² keine Verbindung eingeht, oder die Distanzstücke 40 bestehen aus einem-Glas-und gehen mit den Fasern 121 unter Einwirkung von Wärme und Druck eine stoffschlüssige Verbindung ein.

Es ist zur definierten Verformung der erwärmten Fasern 121 vorgesehen, dass die beiden Teile des Presswerkzeuges 211, 212 einander soweit angenährt werden, bis die Distanzstücke 40 mit beiden Pressflächen 201, 202 in Kontakt kommen. Der zwischen den Pressflächen 201,202 verbleibende Spalt ist somit durch die durch die Distanzstücke 40 gegebene Maßverkörperung definiert.

Wie im vorangegangenen Beispiel können das erste Teil 211 und das zweite Teil 212 des Presswerkzeugs 200 im engen Wortsinn Werkzeuge, beispielsweise aus SiC, sein, die mit den Fasern 121 auch unter Einwirkung von Wärme und Druck, zum Beispiel bei Temperaturen bis 800°C und Drücken bis 50 N/cm², keine Verbindung eingehen. Andererseits ist es möglich, dass das erste Teil 211 des Presswerkzeugs 200 ein Faserträger 20 ist und/oder das zweite Teil 212 des Presswerkzeugs 200 ein zweiter Faserträger 21 ist, wobei der Faserträger 20 und/oder der zweite Faserträger 21 bevorzugt aus einem Glas besteht und mit den Fasern 121, und optional auch mit den Distanzstücken 40 unter Einwirkung von Wärme und Druck eine stoffschlüssige Verbindung eingeht. Eine Verformung der Distanzstücke 40 wird bevorzugt vermieden.

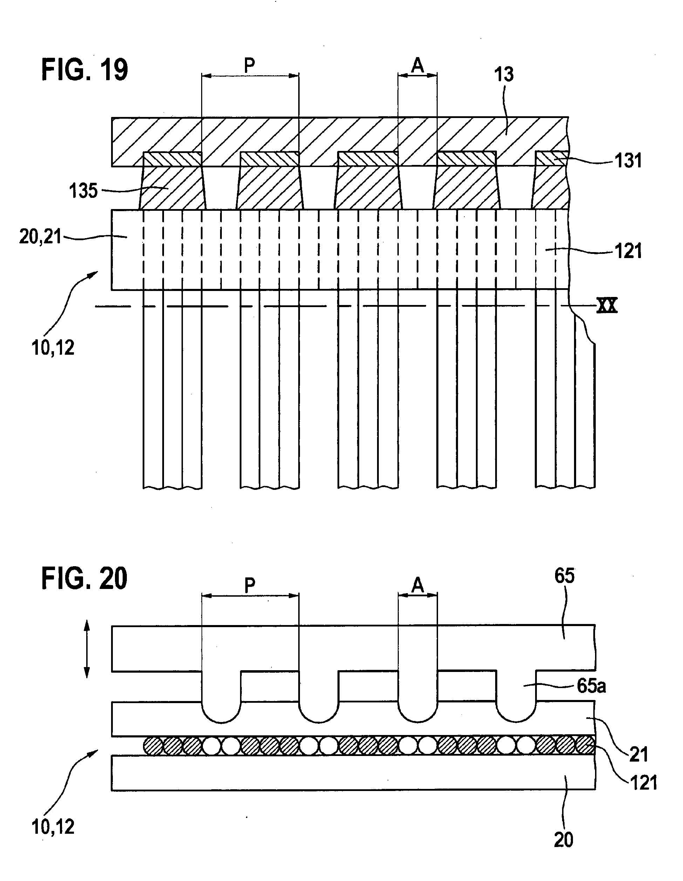

Die Figuren 19 und 20 zeigen ein weiteres Ausführbeispiel einer Lichtquelle 10, die einen Diodenlaser 13 und eine Lichtleiteinrichtung 12 umfasst. Wie in den vorangehenden Beispielen wirken der Diodenlaser 13 und die Lichtleiteinrichtung 12 derart zusammen, dass der Diodenlaser 13 eine Vielzahl von nebeneinander angeordneten Emittern 131 umfasst, denen gegenüber eine Vielzahl von Fasern 121 angeordnet ist, in die die Emission 135 der Emitter 131 des Diodenlasers 13 einkoppelt.

Aus der Anordnung der Emitter 131 und der Fasern 121 und aus den räumlichen Eigenschaften der Emission 135 der Emitter 131 des Diodenlasers 13 resultiert, dass in einige der Fasern 121 ein Teil der Emission 135 der Emitter 131 einkoppelt, in andere hingegen kein oder wenig Licht. Es ist vorgesehen, dass diejenigen Fasern 121, in die kein oder wenig Licht einkoppelt, mittels einer als Rastermesser 65 ausgebildeten Schneidvorrichtung, vorzugsweise in der Nähe des Faserträgers 20, durchtrennt werden. Die Durchtrennung der Fasern 121 mit dem Rastermesser 65 kann insbesondere unmittelbar an der Kante des Faserträgers 20 erfolgen, an der die Fasern 121 über den Faserträger 20 hinausragen. Das Rastermesser 65 weist Schneidelemente 65a mit einer Breite A auf, wobei die Breite A identisch oder nahezu identisch ist mit der Breite der Zwischenräume zwischen den Emittern 131 des Diodenlasern 13. Der Abstand P der Schneidelemente 65a untereinander ist identisch oder nahezu identisch mit dem Abstand P, den die Emitter 131 untereinander aufweisen. Unter nahezu identisch wird hierbei maximal diejenige Abweichung verstanden, die der räumlichen Aufweitung der Emission 135 der Emitter 131 zwischen der Austrittsflächen der Emitter 131 und den Stirnflächen 1216 der Fasen 121 in der Slow-Axis entspricht.

Die Durchtrennung der Fasern 121 mit dem Rastermesser 65 erfolgt vorzugsweise, indem in einem ersten Schritt das Rastermessermesser 65 so vor dem Diodenlaser 13 positioniert wird, dass die Schneidelemente 65a zwischen die Emittern 131 des Diodenlasers 13 gelangen. Letzteres kann dadurch erreicht werden, dass die Emitter 131 des Diodenlasers 13 Licht emittieren und die durch das Rastermesser 65 gestrahlte Lichtmenge bezüglich seitlicher Verschiebung des Rastermessers 65 maximiert wird. Nachfolgend erfolgt ein Anheben des Rastermessers 65, eine Positionierung der Lichtleiteinrichtung 12 vor dem Diodenlaser 13 und abschließend das Durchtrennen der unbeleuchteten oder wenig beleuchteten Fasern 121 durch Absenken des Rastermessers 65.

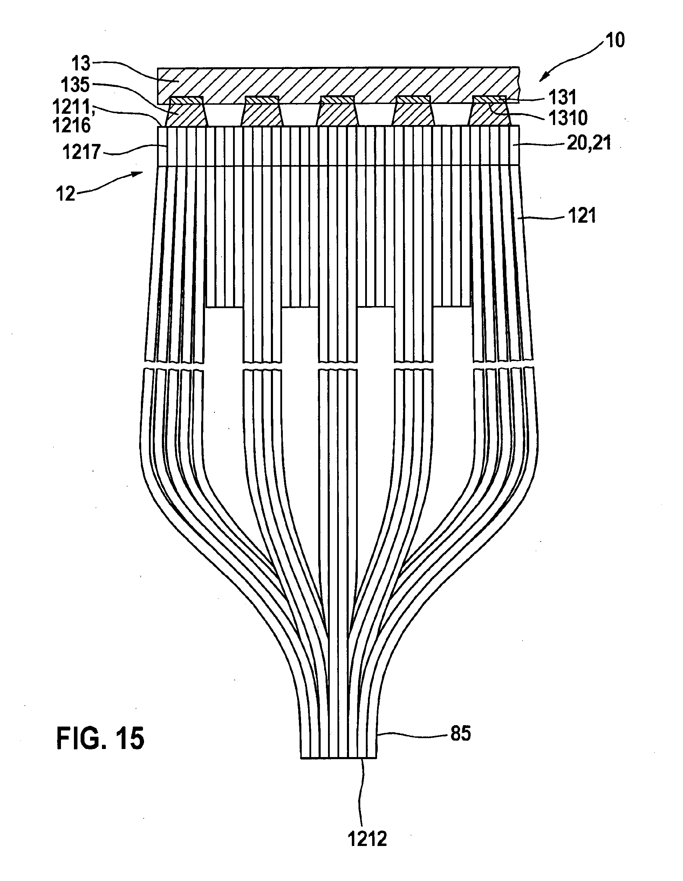

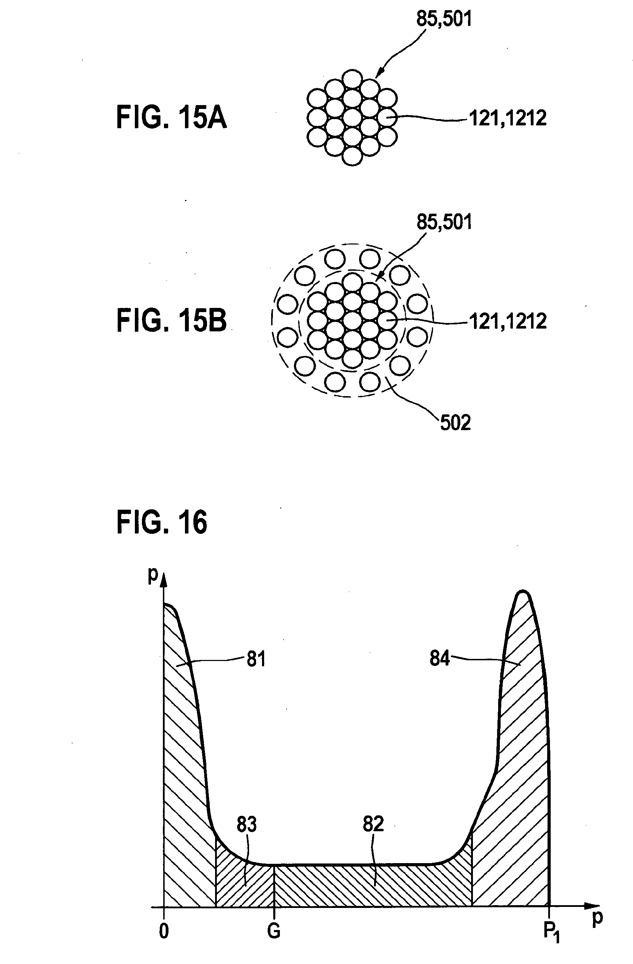

Die Figuren 15, 15a und 15b zeigen ein weiteres Ausführbeispiel einer Lichtquelle 10, die einen Diodenlaser 13 und eine Lichtleiteinrichtung 12 umfasst, die wie im vorangehenden Beispiel zusammenwirken. Aus der Anordnung der Emitter 131 und der Fasern 121 und aus den räumlichen Eigenschaften der Emission 135 der Emitter 131 des Diodenlasers 13 resultiert, dass in Fasern 121 unterschiedlich viel der Emission 135 der Emitter 131 des Diodenlasers 13 und somit unterschiedlich viel optische Strahlung, einkoppelt. In Fasern 121, die in Bereichen angeordnet sind, die Zwischenräumen von Emittern 131, gegenüberliegen, koppelt praktisch keine Strahlung ein. In Fasern 121, die Emittern 121 eher zentral gegenüberliegen, koppelt etwa gleich viel Strahlung, Strahlung der Strahlungsleistung P₁, ein. In Fasern 121, die Randbereichen von Emittern 121 gegenüberliegen koppelt Strahlung ein, deren Strahlungsleistung zwischen Null und P₁ liegt.

In Figur 16 ist die resultierende Häufigkeitsverteilung p der in die Fasern 121 eingekoppelten Strahlungsleistung P dargestellt. Es ist ersichtlich, dass es neben einer ersten Gruppe 84 von Fasern 121, in die etwa die Strahlungsleistung P₁ einkoppelt und einer zweiten Gruppe 81 von Fasern 121, in die keine oder nahezu keine Strahlungsleistang einkoppelt, eine dritte Gruppe 83 von Fasern 121-gibt, in die Strahlung einkoppelt, deren Strahlungsleistung zwischen Null und einem Grenzwert G liegt. Ferner gibt es eine vierte Gruppe 82 von Fasern 121, in die Strahlung einkoppelt, deren Strahlungsleistung zwischen dem Grenzwert G und P₁ liegt.

Es ist vorgesehen, dass die Fasern 121 der ersten und der vierten Gruppe 82, 84 einen ersten Teil 501 (Figur 15 a) der optischen Fasern 121 bilden und im Bereich ihrer zweiten Enden 1212 zu einem Bündel 85 zusammengefasst, insbesondere unter Einwirkung von Druck und Wärme miteinander verbunden und/oder verdichtet, sind.

In Figur 15b ist eine weitere Ausführungsform schematisch dargestellt, bei der die Fasern 121 eines zweiten Teils 502 der Fasern 121, in die jeweils weniger Licht einkoppelt, als in die Fasern 121 des ersten Teils 501 der optischen Fasern 121, um das Bündel 85 herum angeordnet ist.

Eine derartige Lichtquelle 10 kann zum Beispiel hergestellt werden, indem eine Lichtleiteinrichtung 12, wie vorangehend beschrieben, vor einem Diodenlaser 13 angeordnet wird. Durch Beaufschlagung des Diodenlasers 13 mit einem Betriebsstrom wird der Diodenlaser 13 im Bereich der Emitter 131 zur Emission von Licht angeregt. Dieses Licht koppelt überwiegend in die Fasern 121 der Lichtleiteinrichtung 12 ein, wobei in jede individuelle Faser 121 eine Strahlung mit einer Strahlungsleistung P einkoppelt. Es ist vorgesehen, dass diese Strahlungsleistung für jede individuelle Faser 121 erfasst wird.

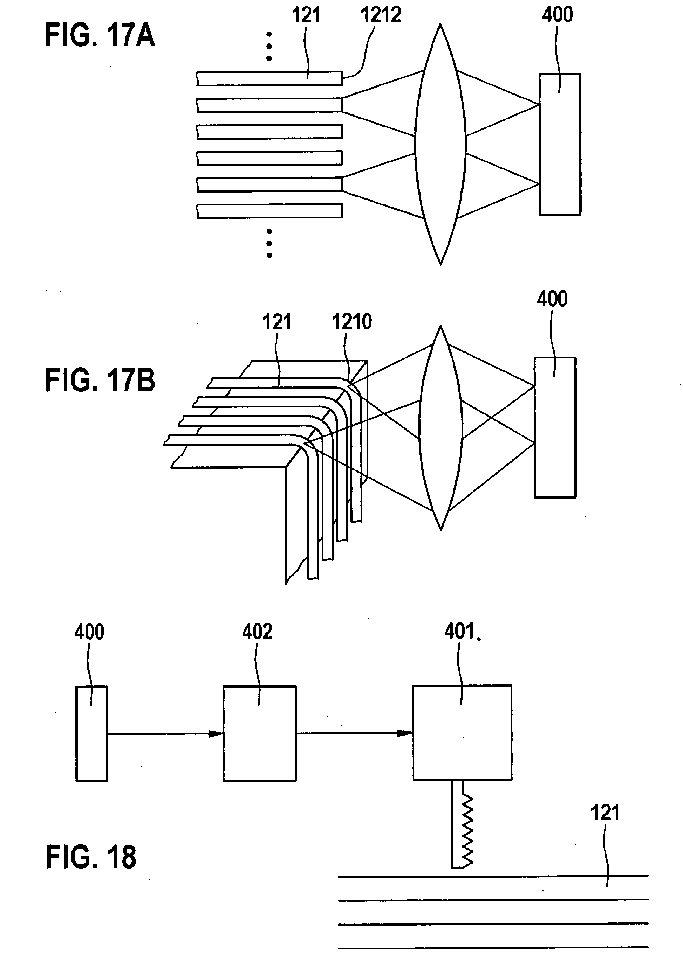

Wie in Figur 17a gezeigt, erfolgt die Erfassung der Strahlungsleistungen beispielsweise, indem die zweiten Enden 1212 der Fasern auf eine CCD Kamera 400 abgebildet werden. Anderseits ist es möglich, wie in Figur 17b gezeigt, die Fasern 121 einer Biegung 1210 auszusetzen, sodass vermehrt Streustrahlung aus ihnen austritt, und diese Streustrahlung auf eine CCD Kamera 400 abzubilden.

Es ist vorgesehen, dass, wie in Figur 18 schematisch dargestellt, die von der CCD Kamera 400 aufgenommenen Bilder einer Steuereinheit 402 zugeführt werden. Durch die Steuereinheit 402 wird entschieden, ob die Strahlungsleistung P der in einer individuellen Faser 121 geführten Strahlung über oder unter dem Grenzwert G liegen. Es ist ferner vorgesehen, dass die Steuereinheit 402 eine Trenneinrichtung 401, z.B. ein CO₂-Lasersystem, so ansteuert, dass die Fasern 121, für die entschieden wurde, dass die Strahlungsleistung der in ihnen geführten Strahlung unter dem Grenzwert G liegt, durchtrennt werden.

Es ist vorgesehen, dass die verbleibenden Fasern 121, das heißt die Fasern 121, für die entschieden wurde, dass die Strahlungsleistung der in ihnen geführten Strahlung über dem Grenzwert G liegt, im Bereich der zweiten Enden 1212 der Fasern 121 zu einem Bündel 85 zusammengefasst werden. Optional ist es möglich die im Bereich der zweiten Enden 1212 zusammengefassten Fasern 121 im Bereich ihrer zweiten Enden 1212 durch Einwirkung von Druck und Wärme zu verdichten und/oder stoffschlüssig miteinander zu verbinden.

Es ist vorgesehen, dass die aus den in dem Bündel 85 zusammengefassten Fasern 121 austretende Strahlung verwendet wird, um einen Festkörperlaser 260 (Figur 2) optisch anzuregen, dessen Emission der Erzeugung eines Zündfunkens zum Zünden einer Verbrennung in einer Brennkraftmaschine 109 dient (Figur 1). Vor diesem Hintergrund wird klar, dass es günstig ist, den Grenzwert G so zu wählen, dass ein Merkmal der Verbrennung in der Brennkraftmaschine 109, insbesondere Leistung, Emissionswerte, Anzahl von Zündaussetzern oder ähnliches, optimiert wird. Andererseits kann der Grenzwert G auch so gewählt werden, dass mindestens eine Eigenschaft der Emission des Festkörperlasers 260, insbesondere Ausgangsleistung des Festkörperlasers 260, Strahlqualität oder Leistungsdichte pro Fläche pro Raumwinkel des Festkörperlasers 260, optimiert wird.

## Patentansprüche

1. Lasereinrichtung (11) mit einer Lichtquelle (10) zu ihrer optischen Anregung, wobei die Lichtquelle einen Diodenlaser (13) mit einer Vielzahl von Emittern (131) und eine Lichtleiteinrichtung (12) umfasst, wobei die Lichtleiteinrichtung (12) eine Vielzahl optischer Fasern (121) umfasst und jede Faser (121) ein erstes Ende (1211) und eine Seitenfläche (1217) aufweist, wobei die ersten Enden (1211) derart zu den Emittern (131) angeordnet sind, dass durch die Emitter (131) erzeugtes Licht in die ersten Enden (1211) der optischen Fasern (121) einkoppelt, wobei die optischen Fasern (121) zumindest im Bereich ihrer ersten Enden (1211) entlang ihrer Seitenflächen (1217) auf Stoß angeordnet sind und die optischen Fasern (121) im Bereich ihrer ersten Enden (1211) mit einem Faserträger (20) verbunden sind, **dadurch gekennzeichnet, dass**, die Fasern (121) aus einem oder mehreren ersten Gläsern bestehen und dass der Faserträger (20) aus einem oder mehreren zweiten Gläsern bestehen und dass die Erweichungstemperatur des zweiten Glases oder die Erweichungstemperaturen der zweiten Gläser einen höheren Wert hat/haben als die Erweichungstemperatur des ersten Glases oder die Erweichungstemperaturen der ersten Gläser.

2. Lasereinrichtung (11) nach Anspruch 1, **dadurch gekennzeichnet, dass** der Faserträger (20) im Bereich der ersten Enden (1211) der optischen Fasern (20) mit den Seitenflächen (1217) der Fasern (121) verbunden ist.

3. Lasereinrichtung (11) nach Anspruch 1 oder 2, **dadurch gekennzeichnet, dass** die Fasern (121) mit dem Faserträger (20) stoffschlüssig verbunden sind.

4. Lasereinrichtung (11) nach einem der vorangehenden Ansprüche, **dadurch gekennzeichnet, dass** der Faserträger (20) in Längsrichtung der optischen Fasern (121) bündig mit den optischen Fasern (121) abschließt.

5. Lasereinrichtung (11) nach einem der vorangehenden Ansprüche, **dadurch gekennzeichnet, dass** die Lichtleiteinrichtung (12) einen zweiten Faserträger (21) umfasst, wobei die optischen Fasern (121) im Bereich ihrer ersten Enden (1211) zwischen den Faserträgern (20, 21) angeordnet sind

6. Lasereinrichtung (11) nach Anspruch 5, **dadurch gekennzeichnet, dass** die optischen Fasern (121) mit den Faserträgern (20, 21) stoffschlüssig verbunden sind und/oder dass die Faserträger (20, 21) in Längsrichtung der optischen Fasern (121) bündig miteinander und mit den optischen Fasern (121) abschließen.

7. Lasereinrichtung (11) nach einem der Ansprüche 5 oder 6, **dadurch gekennzeichnet, dass** die Fasern (121) aus einem oder mehreren ersten Gläsern bestehen und dass die Faserträger (20,21) aus einem oder mehreren zweiten Gläsern bestehen und dass die Erweichungstemperatur des zweiten Glases oder die Erweichungstemperaturen der zweiten Gläser einen höheren Wert hat/haben als die Erweichungstemperatur des ersten Glases oder die Erweichungstemperaturen der ersten Gläser.

8. Lasereinrichtung (11) nach Anspruch 7, **dadurch gekennzeichnet, dass** die Erweichungstemperatur des zweiten Glases oder der zweiten Gläser einen um 20 bis 250, insbesondere 20 bis 150 K höheren Wert hat als die Erweichungstemperatur des ersten Glases oder der ersten Gläser.

9. Lasereinrichtung (11) nach einem der vorangehenden Ansprüche, **dadurch gekennzeichnet, dass** die Fasern (121) aus einem oder mehreren ersten Gläsern bestehen und dass der Faserträger (20) oder die Faserträger (20,21) aus einem oder mehreren zweiten Gläsern bestehen und dass die Härte bei Raumtemperatur des zweiten Glases oder die Härten bei Raumtemperatur der zweiten Gläser einen niedrigeren Wert hat/haben als die Härte bei Raumtemperatur des ersten Glases oder die Härten bei Raumtemperatur der ersten Gläser.

10. Lasereinrichtung (11) nach einem der vorangehenden Ansprüche, **dadurch gekennzeichnet, dass** die Fasern (121) aus einem oder mehreren ersten Gläsern bestehen und dass der Faserträger (20) oder die Faserträger (20,21) aus einem oder mehreren zweiten Gläsern bestehen und dass sich der Wärmeausdehnungskoeffizient des ersten Glases oder die Wärmeausdehnungskoeffizienten der ersten Gläser von dem Wärmeausdehnungskoeffizient des zweiten Glases oder der Wärmeausdehnungskoeffizienten der zweiten Gläser um höchstens 5% im Temperaturbereich zwischen den Erweichungstemperaturen der Gläser und Zimmertemperatur unterscheidet.

11. Lasereinrichtung (11) nach einem der vorangehenden Ansprüche, **dadurch gekennzeichnet, dass** im Bereich der ersten Enden (1211) der Fasern (121) in den Bereichen, in denen die Fasern (121) einander berühren und/oder in den Bereichen, in denen die Fasern (121) den Faserträger (20) oder die Faserträger (20, 21) berühren, die Querschnittsflächen der Fasern (121) einen größeren Krümmungsradius aufweisen als in den Bereichen, in denen die Fasern (121) weder einander noch den Faserträger (20) oder die Faserträger (20, 21) berühren.

12. Lasereinrichtung (11) nach Anspruch 11, **dadurch gekennzeichnet, dass** die Fasern (121) zumindest im Bereich ihrer ersten Enden (1211) einen nahezu rechteckigen Querschnitt, insbesondere mit einem Seitenverhältnis von etwa Pi zu 4 aufweisen.

13. Lasereinrichtung (11) nach einem der vorangehenden Ansprüche, **dadurch gekennzeichnet, dass** die Fasern (121) innerhalb des Bereichs ihrer ersten Enden (1211) einen ersten Teilbereich (121a) aufweisen, der den Stirnflächen (1216) der Fasern (121) zugewandt ist, und dass die Fasern (121) innerhalb des Bereichs ihrer ersten Enden (1211) einen zweiten Teilbereich (121b) aufweisen, der von den Stirnflächen (1216) beabstandet ist, wobei eine Querschnittsfläche der Fasern (121) im ersten Teilbereich (121a) stärker von einer runden Fläche abweicht als eine Querschnittsfläche der Fasern (121) im zweiten Teilbereich (121b).

14. Lasereinrichtung (11) nach Anspruch 13, **dadurch gekennzeichnet, dass** die Stirnflächen (1216) der Fasern (121) einen zumindest nahezu trapezförmigen oder nahezu rechteckigen, insbesondere trapezförmigen oder rechteckigen, Querschnitt aufweisen und die Querschnittsflächen der Fasern (121) innerhalb des Bereichs der ersten Enden (1211) der Fasern (121) entlang der Längsachsen (1219) der Fasern (121) in einen nahezu runden, insbesondere runden Querschnitt übergehen.

15. Läsereinrichtung (11) nach einem der vorangehenden Ansprüche, **dadurch gekennzeichnet, dass** sich die Querschnittsfläche der Fasern (121) beim Übergang von dem Bereich, in dem die Fasern auf dem Faserträger (20) oder auf den Faserträgern (20,21) angeordnet sind, zu dem Bereich, in dem die Fasern (121) nicht auf dem Faserträger (20) oder den Faserträgern (20,21) angeordnet sind, nicht sprunghaft ändert, sondern weitgehend unverändert, insbesondere rund bleibt.

16. Verfahren zur Herstellung einer Lasereinrichtung (11) nach einem der vorangehenden Ansprüche, **gekennzeichnet durch** folgende Verfahrensschritte:
- Anordnen einer Vielzahl von Fasern (121) auf einem Faserträger (20),
- Erwärmen der angeordneten Fasern (121) im Bereich ihrer ersten Enden (1211),
- Ausbildung einer Verbindung zwischen den erwärmten Fasern (121) und dem - Faserträger (20).

17. Verfahren nach Anspruch 16, **dadurch gekennzeichnet, dass** die Fasern (121) zumindest im Bereich ihrer ersten Enden (1211) entlang ihrer Seitenflächen (1217) untereinander auf Stoß auf dem Faserträger (20) angeordnet sind.

18. Verfahren nach Anspruch 16 oder 17, **dadurch gekennzeichnet, dass** es bei dem Erwärmen der Fasern (121) zu einer Erweichung der Fasern (121) kommt.

19. Verfahren nach einem der Ansprüche 16 bis 18, **dadurch gekennzeichnet, dass** während oder nach dem Erwärmen eine Kraft auf die Fasern (121) ausgeübt wird und die Kraft senkrecht zur Auflagefläche der Fasern (121) auf dem Faserträger (20) gerichtet ist.

20. Verfahren nach einem der Ansprüche 16 bis 18, **dadurch gekennzeichnet, dass** während oder nach dem Erwärmen eine Kraft auf die Fasern (121) ausgeübt wird und die Kraft zur Normalen der Auflagefläche der Fasern (121) auf dem Faserträger (20) einen Winkel von 0,1° bis 2,5° bildet, sodass es zu einer ungleichmäßigen Verpressung kommt.

21. Verfahren nach einem der Ansprüche 16 bis 20, **dadurch gekennzeichnet, dass** es bei der Ausbildung einer Verbindung zwischen den erwärmten Fasern (121) zu einer Verformung der Fasern (121) kommt, wobei es zur Ausbildung eines Stoffschlusses zwischen den Fasern (121) und dem Faserträger (20) kommt.

22. Verfahren nach einem der Ansprüche 16 bis 21, **dadurch gekennzeichnet, dass** ein Stoffschluss zwischen den Fasern (121) vermieden wird.

23. Verfahren nach Anspruch 19, **dadurch gekennzeichnet, dass** während der Einwirkung der Kraft auf die Fasern (121) die Fasern (121) zwischen dem Faserträger (20) und einer Gegenfläche (22) angeordnet sind, wobei die auf die Fasern (121) wirkende Kraft mittels der Gegenfläche (22) auf die Fasern (121) einwirkt.

24. Verfahren nach Anspruch 23, **dadurch gekennzeichnet, dass** die Gegenfläche (22) aus einem wärmebeständigen Material besteht, das mit den Fasern (121) auch bei Temperaturen von 800°C keine Verbindung eingeht, zum Beispiel SiC.

25. Verfahren nach Anspruch 23, **dadurch gekennzeichnet, dass** die Gegenfläche (22) Teil eines zweiten Faserträgers (21) ist, wobei sich der zweite Faserträger (21) ebenfalls mit den Fasern (121) verbindet.

## Claims

1. Laser device (11) with a light source (10) for its optical excitation, the light source comprising a diode laser (13) with a plurality of emitters (131) and a light-guiding device (12), the light-guiding device (12) comprising a plurality of optical fibres (121) and each fibre (121) having a first end (1211) and a lateral surface (1217), the first ends (1211) being arranged in relation to the emitters (131) in such a way that light generated by the emitters (131) is coupled into the first ends (1211) of the optical fibres (121), the optical fibres (121) being arranged in abutting relationship along their lateral surfaces (1217), at least in the region of their first ends (1211), and the optical fibres (121) being bonded in the region of their first ends (1211) to a fibre support (20), **characterized in that** the fibres (121) consist of one or more first types of glass and **in that** the fibre support (20) consists of one or more second types of glass and **in that** the softening temperature of the second type of glass or the softening temperatures of the second types of glass has/have a higher value than the softening temperature of the first type of glass or the softening temperatures of the first types of glass.

2. Laser device (11) according to Claim 1, **characterized in that** the fibre support (20) is bonded to the lateral surfaces (1217) of the fibres (121) in the region of the first ends (1211) of the optical fibres (20).

3. Laser device (11) according to Claim 1 or 2, **characterized in that** the fibres (121) are integrally bonded to the fibre support (20).

4. Laser device (11) according to one of the preceding claims, **characterized in that** the fibre support (20) finishes flush with the optical fibres (121) in the longitudinal direction of the optical fibres (121).

5. Laser device (11) according to one of the preceding claims, **characterized in that** the light-guiding device (12) comprises a second fibre support (21), the optical fibres (121) being arranged in the region of their first ends (1211) between the fibre supports (20, 21).

6. Laser device (11) according to Claim 5, **characterized in that** the optical fibres (121) are integrally bonded to the fibre supports (20, 21) and/or **in that** the fibre supports (20, 21) finish flush with one another and with the optical fibres (121) in the longitudinal direction of the optical fibres (121).

7. Laser device (11) according to either of Claims 5 and 6, **characterized in that** the fibres (121) consist of one or more first types of glass and **in that** the fibre supports (20, 21) consist of one or more second types of glass and **in that** the softening temperature of the second type of glass or the softening temperatures of the second types of glass has/have a higher value than the softening temperature of the first type of glass or the softening temperatures of the first types of glass.

8. Laser device (11) according to Claim 7, **characterized in that** the softening temperature of the second type of glass or the second types of glass has a value that is higher by 20 to 250, in particular 20 to 150 K, than the softening temperature of the first type of glass or the first types of glass.

9. Laser device (11) according to one of the preceding claims, **characterized in that** the fibres (121) consist of one or more first types of glass and **in that** the fibre support (20) or the fibre supports (20, 21) consist(s) of one or more second types of glass and **in that** the hardness at room temperature of the second type of glass or the hardnesses at room temperature of the second types of glass has/have a lower value than the hardness at room temperature of the first type of glass or the hardnesses at room temperature of the first types of glass.

10. Laser device (11) according to one of the preceding claims, **characterized in that** the fibres (121) consist of one or more first types of glass and **in that** the fibre support (20) or the fibre supports (20, 21) consist(s) of one or more second types of glass and **in that** the coefficient of thermal expansion of the first type of glass or the coefficients of thermal expansion of the first types of glass differ (s) from the coefficient of thermal expansion of the second type of glass or the coefficients of thermal expansion of the second types of glass by at most 5% in the temperature range between the softening temperatures of the types of glass and room temperature.

11. Laser device (11) according to one of the preceding claims, **characterized in that**, in the region of the first ends (1211) of the fibres (121), the cross-sectional areas of the fibres (121) have a greater radius of curvature in the regions in which the fibres (121) are in contact with one another and/or in the regions in which the fibres (121) are in contact with the fibre support (20) or the fibre supports (20, 21) than in the regions in which the fibres (121) are not in contact with one another or with the fibre support (20) or the fibre supports (20, 21).

12. Laser device (11) according to Claim 11, **characterized in that**, at least in the region of their first ends (1211), the fibres (121) have a virtually rectangular cross section, in particular with an aspect ratio of approximately pi to 4.

13. Laser device (11) according to one of the preceding claims, **characterized in that** the fibres (121) have within the region of their first ends (1211) a first subregion (121a), which is towards the end faces (1216) of the fibres (121), and **in that** the fibres (121) have within the region of their first ends (1211) a second subregion (121b), which is away from the end faces (1216), a cross-sectional area of the fibres (121) in the first subregion (121a) deviating from a round surface area more than a cross-sectional area of the fibres (121) in the second subregion (121b).

14. Laser device (11) according to Claim 13, **characterized in that** the end faces (1216) of the fibres (121) have an at least virtually trapezoidal or virtually rectangular, in particular trapezoidal or rectangular, cross section and, within the region of the first ends (1211) of the fibres (121), the cross-sectional areas of the fibres (121) go over into a virtually round, in particular round, cross section along the longitudinal axes (1219) of the fibres (121).

15. Laser device (11) according to one of the preceding claims, **characterized in that**, at the transition from the region in which the fibres are arranged on the fibre support (20) or on the fibre supports (20, 21) to the region in which the fibres (121) are not arranged on the fibre support (20) or the fibre supports (20, 21), the cross-sectional area of the fibres (121) does not change abruptly but remains largely unchanged, in particular round.

16. Method for producing a laser device (11) according to one of the preceding claims, **characterized by** the following method steps:
- arranging a plurality of fibres (121) on a fibre support (20),
- heating the arranged fibres (121) in the region of their first ends (1211),
- forming a bond between the heated fibres (121) and the fibre support (20).

17. Method according to Claim 16, **characterized in that**, at least in the region of their first ends (1211), the fibres (121) are arranged on the fibre support (20) in abutting relationship with one another along their lateral surfaces (1217).

18. Method according to Claim 16 or 17, **characterized in that** a softening of the fibres (121) occurs during the heating of the fibres (121).

19. Method according to one of Claims 16 to 18, **characterized in that**, during or after the heating, a force is exerted on the fibres (121) and the force is directed perpendicularly to the contact surface of the fibres (121) on the fiber support (20).

20. Method according to one of Claims 16 to 18, **characterized in that**, during or after the heating, a force is exerted on the fibres (121) and the force forms an angle of 0.1° to 2.5° in relation to the normal to the contact surface of the fibres (121) on the fibre support (20), so that uneven pressing occurs.

21. Method according to one of Claims 16 to 20, **characterized in that** a deformation of the fibres (121) occurs during the forming of a bond between the heated fibres (121), the forming of an integral bond taking place between the fibres (121) and the fibre support (20).

22. Method according to one of Claims 16 to 21, **characterized in that** an integral bond between the fibres (121) is avoided.

23. Method according to Claim 19, **characterized in that**, while the force is acting on the fibres (121), the fibres (121) are arranged between the fibre support (20) and a counter-surface (22), the force that is acting on the fibres (121) acting on the fibres (121) by means of the counter-surface (22).

24. Method according to Claim 23, **characterized in that** the counter-surface (22) consists of a heat-resistant material that does not enter into a bond with the fibres (121) even at temperatures of 800°C, for example SiC.

25. Method according to Claim 23, **characterized in that** the counter-surface (22) is part of a second fibre support (21), the second fibre support (21) likewise bonding to the fibres (121).

## Revendications

1. Dispositif laser (11) comportant une source de lumière (10) destinée à sa stimulation optique, dans lequel la source de lumière comprend une diode laser (13) comportant une pluralité d'émetteurs (131) est un dispositif à guide optique (12), dans lequel le dispositif à guide optique (12) comprend une pluralité de fibres optiques (121) et chaque fibre (121) présente une première extrémité (1211) et une face latérale (1217), dans lequel les premières extrémités (1211) sont disposées par rapport aux émetteurs (131) de manière à ce que la lumière générée par les émetteurs (131) soit injectée dans les premières extrémités (1211) des fibres optiques (121), dans lequel les fibres optiques (121) sont disposées bord à bord, au moins dans la région de leurs premières extrémités (1211), le long de leurs faces latérales (1217) et les fibres optiques (121) sont reliées, dans la région de leurs premières extrémités (1211), à un support de fibres (20), **caractérisé en ce que** les fibres (121) sont constituées d'un ou plusieurs premiers verres et **en ce que** le support de fibres (20) est constitué d'un ou plusieurs seconds verres et **en ce que** la température d'amollissement du second verre ou les températures d'amollissement des seconds verres a/ont une valeur supérieure à la température d'amollissement du premier verre ou aux températures d'amollissement des premiers verres.

2. Dispositif laser (11) selon la revendication 1, **caractérisé en ce que** le support de fibres (20), dans la région des premières extrémités (1211) des fibres optiques (20), est relié aux faces latérales (1217) des fibres (121).

3. Dispositif laser (11) selon la revendication 1 ou 2, **caractérisé en ce que** les fibres (121) sont liées par raccordement de matériau au support de fibres (20).

4. Dispositif laser (11) selon l'une quelconque des revendications précédentes, **caractérisé en ce que** le support de fibres (20) se termine en affleurant aux fibres optiques (121) dans la direction longitudinale des fibres optiques (121).

5. Dispositif laser (11) selon l'une quelconque des revendications précédentes, **caractérisé en ce que** le dispositif à guide optique (12) comprend un second support de fibres (21), dans lequel les fibres optiques (121), dans la région de leurs premières extrémités (1211), sont disposées entre les supports de fibres (20, 21).

6. Dispositif laser (11) selon la revendication 5, **caractérisé en ce que** les fibres optiques (121) sont liées par raccordement de matériau aux supports de fibres (20, 21) et/ou **en ce que** les supports de fibres (20, 21) se terminent en affleurant l'un à l'autre et aux fibres optiques (121) dans la direction longitudinale des fibres optiques (121).

7. Dispositif laser (11) selon l'une quelconque des revendications 5 ou 6, **caractérisé en ce que** les fibres (121) sont constituées d'un ou plusieurs premiers verres et **en ce que** les supports de fibres (20, 21) sont constitués d'un ou plusieurs seconds verres et **en ce que** la température d'amollissement du second verre ou les températures d'amollissement des seconds verres a/ont une valeur supérieure à la température d'amollissement du premier verre ou aux températures d'amollissement des premiers verres.

8. Dispositif laser (11) selon la revendication 7, **caractérisé en ce que** la température d'amollissement du second verre ou des seconds verres à une valeur plus élevée de 20 à 250, et en particulier, de 20 à 150 K, que la température d'amollissement du premier verre ou des premiers verres.

9. Dispositif laser (11) selon l'une quelconque des revendications précédentes, **caractérisé en ce que** les fibres (121) sont constituées d'un ou plusieurs premiers verres et **en ce que** le support de fibres (20) ou les supports de fibres (20, 21) sont constitués d'un ou plusieurs seconds verres et **en ce que** la dureté à la température ambiante du second verre ou les duretés à la température ambiante des seconds verres a/ont une valeur inférieure à la dureté à la température ambiante du premier verre ou aux duretés à la température ambiante des premiers verres.

10. Dispositif laser (11) selon l'une quelconque des revendications précédentes, **caractérisé en ce que** les fibres (121) sont constituées d'un ou plusieurs premiers verres et **en ce que** le support de fibres (20) ou les supports de fibres (20, 21) sont constitués d'un ou plusieurs seconds verres et **en ce que** le coefficient de dilatation thermique du premier vers ou les coefficients de dilatation thermique des premiers verres diffère/diffèrent du coefficient de dilatation thermique du second verre ou des coefficients de dilatation thermique des seconds verres d'au plus 5 % dans une région de température comprise entre les températures d'amollissement des verres et la température ambiante.

11. Dispositif laser (11) selon l'une quelconque des revendications précédentes, **caractérisé en ce que**, dans la région des premières extrémités (1211) des fibres (121), dans les régions dans lesquelles les fibres (121) sont en contact les unes avec les autres et/ou dans les régions dans lesquelles les fibres (121) sont en contact avec le support de fibres (20) ou les supports de fibres (20, 21), les sections transversales des fibres (121) présentent un rayon de courbure plus élevé que dans les régions dans lesquelles les fibres (121) ne sont en contact ni les unes avec les autres ni avec le support de fibres (20) ou les supports de fibres (20, 21).

12. Dispositif laser (11) selon la revendication 11, **caractérisé en ce que** les fibres (121) présentent, au moins dans la région de leurs premières extrémités (1211), une section transversale sensiblement rectangulaire, notamment avec un rapport de dimensions d'environ Pi sur 4.

13. Dispositif (11) selon l'une quelconque des revendications précédentes, **caractérisé en ce que** les fibres (121), à l'intérieur de la région de leurs premières extrémités (1211), comportent une première partie (121a) qui est tournée vers les faces avant (1216) des fibres (121) et **en ce que** les fibres (121), à l'intérieur de la région de leurs premières extrémités (1211) comportent une seconde partie (121b), qui est espacée des faces avant (1216), dans lequel une section transversale des fibres (121) dans la première partie (121a) s'écarte plus fortement d'une surface circulaire qu'une section transversale des fibres (121) dans la seconde partie (121b).

14. Dispositif laser (11) selon la revendication 13, **caractérisé en ce que** les faces avant (1216) des fibres (121) présentent une section transversale au moins approximativement trapézoïdale ou approximativement rectangulaire, notamment trapézoïdale ou rectangulaire, et **en ce que** les sections transversales des fibres (121), à l'intérieur de la région des premières extrémités (1211) des fibres (121), se transforment en une section transversale sensiblement circulaire, notamment circulaire, le long des axes longitudinaux (1219) des fibres (121).

15. Dispositif laser (11) selon l'une quelconque des revendications précédentes, **caractérisé en ce que** les sections transversales des fibres (121), lors de la transition de la région dans laquelle les fibres sont disposées sur le support de fibres (20) ou sur les supports de fibres (20, 21) à la région dans laquelle les fibres (121) ne sont pas disposées sur le support de fibres (20) ou sur les supports de fibres (20, 21), ne varient pas brusquement, mais restent sensiblement inchangées et restent notamment circulaires.

16. Procédé de fabrication d'un dispositif laser (11) selon l'une quelconque des revendications précédentes, **caractérisé par** les étapes consistant à :
- disposer une pluralité de fibres (121) sur un support de fibres (20),
- chauffer les fibres disposées (121) dans la région de leurs premières extrémités (1211),
- établir une liaison entre les fibres chauffées (121) et le support de fibres (20).

17. Procédé selon la revendication 16, **caractérisé en ce que** les fibres (121), au moins dans la région de leurs premières extrémités (1211), sont disposées bord à bord les unes en dessous des autres sur le support de fibres (20), le long de leurs faces latérales (1217).

18. Procédé selon la revendication 16 ou 17, **caractérisé en ce que** le chauffage des fibres (121) conduit à un amollissement des fibres (121).

19. Procédé selon l'une quelconque des revendications 16 à 18, **caractérisé en ce que**, pendant ou après le chauffage, une force est exercée sur les fibres (121) et **en ce que** la force est dirigée perpendiculairement à la surface d'appui des fibres (121) sur le support de fibres (20).

20. Procédé selon l'une quelconque des revendications 16 à 18, **caractérisé en ce que**, pendant ou après le chauffage, une force est exercée sur les fibres (121) et **en ce que** la force forme un angle de 0,1° à 2,5° par rapport à des normales à la surface d'appui des fibres (121) sur le support de fibres (20).

21. Procédé selon l'une quelconque des revendications 16 à 20, **caractérisé en ce que**, lors de l'établissement d'une liaison entre les fibres chauffées (121), il se produit une déformation des fibres (121) conduisant à l'établissement d'un raccord de matériau entre les fibres (121) et le support de fibres (20).

22. Procédé selon l'une quelconque des revendications 16 à 21, **caractérisé en ce qu'**un raccord de matériau entre les fibres (121) est évité.

23. Procédé selon la revendication 19, **caractérisé en ce que**, pendant que la force agit sur les fibres (121), les fibres (121) sont disposés entre le support de fibres (20) et une contre-surface (22), dans lequel la force agissant sur les fibres (121) à un effet sur les fibres (121) par l'intermédiaire de la contre-surface (22).

24. Procédé selon la revendication 23, **caractérisé en ce que** la contre-surface (22) est constituée d'un matériau thermiquement résistant qui ne se lie pas aux fibres (121) même à des températures de 800°C, par exemple du SiC.

25. Procédé selon la revendication 23, **caractérisé en ce que** la contre-surface (22) fait partie d'un second support de fibres (21), dans lequel le second support de fibres (21) se lie également aux fibres (121).
